# EUROPEAN PATENT APPLICATION

(11) **EP 4 362 636 A1**
(43) Date of publication of application: **01.05.2024**
(21) Application number: 23204928.8
(22) Date of filing: 20.10.2023
(51) Int. Cl.: H10K 59/122, H10K 59/123, H10K 59/80

(54) **DISPLAY PANEL**

(30) Priority: 24.10.2022 KR 20220137499
(71) Applicant: Samsung Display Co., Ltd., Gyeonggi-Do (KR)
(72) Inventor: KO, Yoomin, Yongin-si (KR); PARK, Juchan, Yongin-si (KR); HONG, Sungjin, Yongin-si (KR); KIM, Sunho, Yongin-si (KR); KIM, Hyewon, Yongin-si (KR); LEE, Pilsuk, Yongin-si (KR); CHOI, Chung Sock, Yongin-si (KR)
(74) Representative: Marks & Clerk LLP

(57) **Abstract**

Disclosed is a display panel including a first emitting part and a second emitting part spaced apart from each other. Each of the first and second emitting parts includes a separator and at least one emitting part. The separator includes a first isolation portion. The first isolation portion includes first portions spaced apart from each other and second portions, each of the second portions is bent from each of the first portions and is disposed between adjacent ones of the first portions.

## Description

### BACKGROUND

### 1. Technical Field

Embodiments described herein relate to a display panel including a separator isolating electrodes of a light emitting device from each other.

### 2. Description of the Related Art

Each of multimedia display devices such as televisions, mobile phones, tablets, computers, navigation devices, and game consoles has a display panel for displaying an image. The display panel may include a light emitting device and a driver for an operation of the light emitting device. Research on a connection between the light emitting device and the driver in order to improve characteristics of the display panel is being conducted.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide a display panel including a separator with improved isolation ability.

The technical objectives to be achieved by the disclosure are not limited to those described herein, and other technical objectives that are not mentioned herein would be clearly understood by a person skilled in the art from the description of the disclosure.

According to an embodiment, a display panel may include a first light-emitting unit and a second light-emitting unit spaced apart from each other, wherein each of the first emitting part and the second emitting part may include a separator and at least one emitting part, the separator may include a first isolation portion, the first isolation portion may include first portions spaced apart from each other, and second portions, each of the second portions is disposed between adjacent ones of the first portions, each of the second portions is bent from each of the first portions.

Each of the second portions may extend in a first direction and each of the second portions may extend in a second direction intersecting the first direction.

The first isolation portion may further include third portions, each of the third portions may be disposed between adjacent ones of the first portions, each of the third portions may be bent from each of the first portions, and each of the third portions may be spaced apart from each of the second portions.

Two first portions adjacent to each other among the first portions, a second portion disposed between the two adjacent first portions among the second portions, and a third portion disposed between the two adjacent first portions among the third portions may define a first opening.

Each of the third portions may extend in parallel to a direction in which each of the second portions extends.

The first isolation portion may include at least two first isolation portions, the separator may further include an intersection disposed between the two first isolation portions, wherein a first width in a first direction of the intersection may be greater than a width in the first direction of each of the two first isolation portions.

An edge of the emitting part and an edge of the intersection may have a same curvature in a plan view.

The separator may further include a second isolation portion extending from the intersection in a direction intersecting a direction in which the first isolation portion extends, a second width in a second direction of the intersection may be greater than a width in the second direction of the second isolation portion, wherein the first direction intersects the second direction.

The second isolation portion may include fourth portions spaced apart from each other, and fifth portions, each of the fifth portions may be disposed between adjacent ones of the fourth portions, and each of the fifth portions may be bent from each of the fourth portions.

The second isolation portion may further include sixth portions, each of the sixth portions may be disposed between adjacent ones of the fourth portions, each of the sixth portions may be bent from each of the fourth portions, and each of the sixth portions may be spaced apart from each of the fifth portions.

Each of the first light-emitting unit and the second light-emitting unit may include first emitting parts, second emitting parts and third emitting parts, each configured to emit light of a different color.

The display panel may further include first light emitting devices, second light emitting devices and third light emitting devices, wherein each of the first light emitting devices, the second light emitting devices and the third light emitting devices may include a first electrode, a second electrode facing the first electrode, and a light-emitting layer disposed between the first electrode and the second electrode, wherein the first light emitting devices, the second light emitting devices and the third light emitting devices may respectively correspond to the first emitting parts, the second emitting parts and the third emitting parts, and first transistors, second transistors and third transistors respectively connected to the first light emitting devices, the second light emitting devices and the third light emitting devices, wherein the separator may isolate the second electrodes of the first light emitting devices, the second light emitting devices and the third light emitting devices from each other.

The display panel may further include first connection wirings, second connection wirings and third connection wirings respectively connecting the first light emitting devices, the second light emitting devices and the third light emitting devices and the first transistor, the second transistor and the third transistor to each other, wherein each of the first connection wirings, the second connection wirings and the third connection wirings may include each of first emission connection parts, second emission connection parts and third emission connection parts connected to each corresponding one of the first light emitting devices, the second light emitting devices and the third light emitting devices, and each of first driver connection parts, second driver connection parts and third driver connection parts connected to each corresponding one of the first transistor, the second transistor and the third transistor, wherein each of the first emission connection parts, the second emission connection parts and the third emission connection parts may be connected to each of the second electrodes of the first light emitting devices, the second light emitting devices and the third light emitting devices.

The separator may include one face, another face facing one face, and a side face disposed between the one face and the another face, wherein the side face may be inclined with respect to the one face in a cross-sectional view.

The side face may include a first side face and a second side face spaced apart from the first side face in a direction perpendicular to a thickness direction, a first angle at which the first side face is inclined with respect to the one face and a second angle at which the second side face is inclined with respect to the one face may be different from each other.

The another face may include a groove, wherein the groove may be defined by a first inner side face, a second inner side face spaced apart from the first inner side face, and an inner bottom face disposed between the first inner side face and the second inner side face, wherein each of the first inner side face and the second inner side face may be inclined with respect to the inner bottom face.

According to the disclosure, a display panel may include a first light-emitting unit and a second light-emitting unit spaced apart from each other, wherein each of the first light-emitting unit and the second light-emitting unit may include a separator, at least one light emitting device, and at least one transistor, wherein the separator may include at least two first isolation portions extending in a first direction and spaced apart from each other, and an intersection disposed between the at least two first isolation portions, wherein a first width in a second direction of the intersection is greater than a width in the second direction of one of the at least one first isolation portion, wherein the second direction intersects the first direction.

Each of the first light-emitting unit and the second light-emitting unit may include an emitting part corresponding to the at least one light emitting device and configured to emit light, wherein an edge of the emitting part and an edge of the intersection may have a same curvature in a plan view.

The separator may further include a second isolation portion extending from the intersection in the second direction, wherein a second width in the first direction of the intersection may be greater than a width in the first direction of the second isolation portion.

The intersection may have a substantially rectangular shape in which a second opening is defined in a plan view.

The intersection may include four outer edges defining the substantially rectangular shape, and inner edges respectively spaced apart from the outer edges and defining the second opening, each of the first width and the second width may be defined as a straight line distance between two outer edges spaced apart from each other among the four outer edges.

Each of the at least two first isolation portions may include first portions spaced apart from each other, and second portions, wherein each of the second portions may be disposed between adjacent ones of the first portions, wherein each of the second portions is bent from each of the first portions.

Each of the first light-emitting unit and the second light-emitting unit may include first emitting parts, second emitting parts and third emitting parts, each configured to emit light of a different color.

The first light-emitting unit may include a first light emitting device and a first transistor electrically connected to the first light emitting device, wherein the second light-emitting unit may include a second light emitting device and a second transistor electrically connected to the second light emitting device, each of the first light emitting device and the second light emitting device may include a first electrode, a second electrode facing the first electrode, and a light-emitting layer disposed between the first electrode and the second electrode, the separator may isolate the second electrode of the first light emitting device and the second electrode of the second light emitting device from each other while the separator is disposed between the second electrode of the first light emitting device and the second electrode of the second light emitting device.

The display panel may further include a first connection wiring electrically connecting the first light emitting device to the first transistor, and a second connection wiring electrically connecting the second light emitting device to the second transistor, wherein each of the first connection wiring and the second connection wiring may include an emission connection part electrically connected to the at least one corresponding light emitting device, and a driver connection part electrically connected to the at least one corresponding transistor, wherein the emission connection part of the first connection wiring may be electrically connected to the second electrode of the first light emitting device, wherein the emission connection part of the second connection wiring may be electrically connected to the second electrode of the second light emitting device.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings in which:
FIG. 1 is a block diagram of a display device according to an embodiment;
FIG. 2A is a schematic diagram of an equivalent circuit diagram of a pixel according to an embodiment;
FIG. 2B is a schematic diagram of an equivalent circuit diagram of a pixel according to an embodiment;
FIG. 3A is a schematic plan view showing a display panel according to an embodiment;
FIG. 3B is a schematic plan view showing a display panel according to an embodiment;
FIG. 4A is an enlarged schematic plan view showing a partial area of a display panel according to an embodiment;
FIG. 4B is an enlarged schematic plan view of a XX' area of FIG. 4A;
FIG. 4C is an enlarged schematic plan view showing a partial area of the display panel according to an embodiment;
FIG. 5 is a schematic cross-sectional view showing a portion corresponding to line I-I' of FIG. 4B;
FIG. 6 is an enlarged schematic cross-sectional view showing an area YY' of FIG. 5;
FIG. 7A is an enlarged schematic cross-sectional view of an area ZZ' of FIG. 5;
FIG. 7B is a schematic cross-sectional view showing a separator according to an embodiment;
FIG. 7C is a schematic cross-sectional view showing a separator according to an embodiment;
FIG. 8 is an enlarged schematic plan view showing a partial area of a display panel according to an embodiment;
FIG. 9A is an enlarged schematic plan view of an area FF' of FIG. 8;
FIG. 9B is an enlarged schematic plan view showing a partial area of the separator according to an embodiment;
FIG. 10A is an enlarged schematic plan view of an area HH' of FIG. 8;
FIG. 10B is an enlarged schematic plan view showing a partial area of the separator according to an embodiment;
FIG. 11 is an enlarged schematic plan view of an area GG' in FIG. 8;
FIG. 12 is an enlarged schematic plan view showing a partial area of a display panel according to an embodiment; and
FIG. 13 is an enlarged schematic plan view of an area GG'-1 in FIG. 12.

### DETAILED DESCRIPTION OF THE EMBODIMENTS

The disclosure may have various changes and various forms. Thus, embodiments will be illustrated in the drawings and described in detail herein. However, it should be understood that the embodiments are not intended to limit the disclosure to the disclosed forms. The disclosure includes all modifications, equivalents, and substitutes included in the scope of the disclosure.

As used herein, when a component (or a region, a layer, a portion, and the like) is referred to as being "on", "connected to", or "coupled to" another component, it means that the component may be directly disposed/connected/coupled on another component or a third component or other components may be disposed between the component and another component.

Like reference numerals refer to like components. In the drawings, thicknesses, ratios, and dimensions of components are exaggerated for effective description of technical content.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Terms such as first, second, and the like may be used to describe various components, but the components should not be limited by the terms. The above terms are used only for the purpose of distinguishing one component from another. For example, without departing from the scope of the disclosure, a first component may be named as a second component, and similarly, the second component may also be named as the first component.

Terms such as "beneath", "below", "on", "above" are used to describe the relationship of the components illustrated in the drawings. The above terms are relative concepts, and are described with reference to directions indicated in the drawings but are not limited thereto.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as `not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

It should be understood that terms such as "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

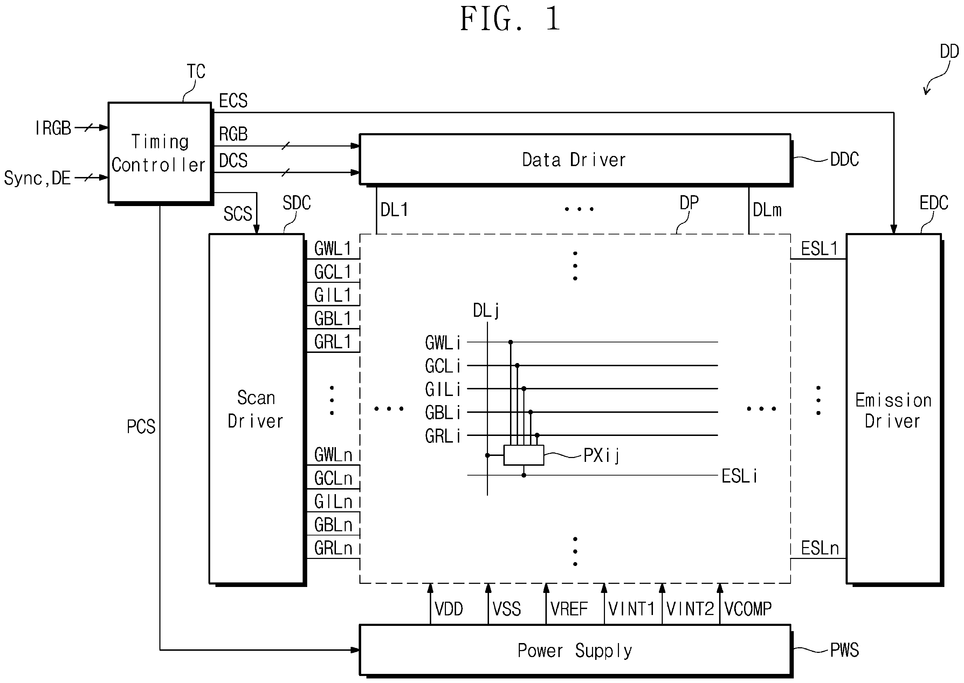

Hereinafter, embodiments of the disclosure will be described with reference to the drawings. FIG. 1 is a block diagram of a display device according to an embodiment.

A display device DD according to an embodiment may be a semiconductor device including at least one semiconductor. The display device DD may include a display panel DP, a panel driver SDC, EDC, and DDC, a power supply PWS, and a timing controller TC. The panel driver may include the scan driver SDC, the emission driver EDC, and the data driver DDC. The display panel DP may display an image according to an electrical signal.

The display panel DP of an embodiment may be a light-emitting display panel, and is not particularly limited. For example, the display panel DP may be an organic light-emitting display panel or an inorganic light-emitting display panel. A light emitting device (LED) of the organic light-emitting display panel may include an organic light-emitting material. A light emitting device of the inorganic light-emitting display panel may include a quantum dot or a quantum rod. Further, a light emitting device of the display panel DP may include a micro LED element and/or a nano LED element. Hereinafter, an example in which the display panel DP is embodied as the light-emitting display panel is described.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm, where m and n are integers greater than 1.

For example, a pixel PXij (where each of i and j is an integer greater than 1) located at an i-th horizontal line (or an i-th pixel row) and a j-th vertical line (or a j-th pixel column) may be connected to the i-th first scan line GWLi (or a write scan line), the i-th second scan line GCLi (or a compensation scan line), the i-th third scan line GILi (or a first initialization scan line), the i-th fourth scan line GBLi (or a second initialization scan line), the i-th fifth scan line GRLi (or a reset scan line), the j-th data line DLj, and the i-th emission line ESLi.

The pixel PXij may include light emitting devices, transistors, and capacitors. The pixel PXij may receive, via the power supply PWS, a first power supply voltage VDD, a second power supply voltage VSS, a third power supply voltage VREF (or a reference voltage), a fourth power supply voltage VINT1 (or a first initialization voltage), a fifth power supply voltage VINT2 (or a second initialization voltage), and a sixth power supply voltage VCOMP (or a compensation voltage).

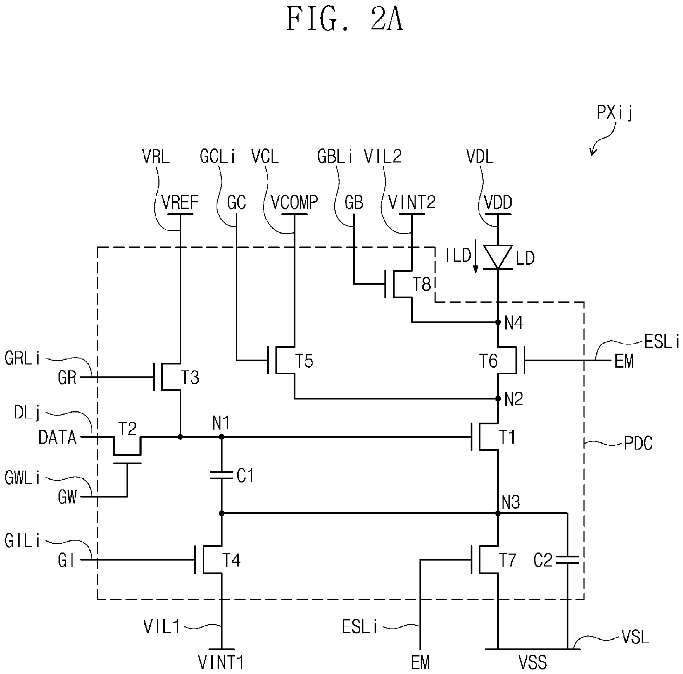

A voltage value of each of the first power voltage VDD and the second power voltage VSS may be set so that current flows in a light emitting device LD (FIG. 2A) included in the pixel PXij to emit light. For example, the first power voltage VDD may be set to a higher voltage level than that of the second power voltage VSS.

The third power voltage VREF may be a voltage for initializing a gate of a driving transistor included in the pixel PXij. The third power voltage VREF may be used to implement a predefined grayscale using a voltage difference between the third power voltage VREF and a voltage of a data signal. To this end, the third power voltage VREF may be set to a predefined voltage within a voltage range of the data signal.

The fourth power voltage VINT1 may be a voltage for initializing a capacitor included in the pixel PXij. The fourth power voltage VINT1 may be set to a voltage level lower than that of the third power voltage VREF. For example, the fourth power voltage VINT1 may be set to a voltage level lower than a difference between the third power voltage VREF and a threshold voltage of the driving transistor. However, an embodiment is not limited thereto.

The fifth power voltage VINT2 may be a voltage for initializing a cathode of the light emitting device included in the pixel PXij. The fifth power voltage VINT2 may be set to a voltage level lower than that of the first power voltage VDD or the fourth power voltage VINT1, or may be set to a voltage level similar to or equal to that of the third power voltage VREF. However, an embodiment is not limited thereto, and the fifth power voltage VINT2 may be set to a voltage level similar to or the same as that of the first power voltage VDD.

The sixth power voltage VCOMP may supply a predefined current to the driving transistor in case that compensating for the threshold voltage of the driving transistor.

In FIG. 1, it is illustrated that all of the first to sixth power voltages VDD, VSS, VREF, VINT1, VINT2, and VCOMP may be supplied from the power supply PWS. However, an embodiment is not limited thereto. For example, all of the first power voltage VDD and the second power voltage VSS may be supplied regardless of a structure of the pixel PXij, and at least one of the third power voltage VREF, the fourth power voltage VINT1, the fifth power voltage VINT2, or the sixth power voltage VCOMP may not be supplied based on the structure of the pixel PXij. Signal lines connected to the pixel PXij may be set in various ways in a corresponding manner to a circuit structure of the pixel PXij.

The scan driver SDC may receive a first control signal SCS from the timing controller TC. Based on the first control signal SCS, the scan driver SDC may supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn. The scan signal may be set to a voltage level such that each of transistors receiving the scan signal may be turned on.

For example, a scan signal supplied to a P-type transistor may be set to a logic low level, and a scan signal supplied to an N-type transistor may be set to a logic high level. Hereinafter, "a scan signal is supplied" may be understood as a scan signal at a logic level that turns on a transistor controlled by the scan signal being supplied.

In FIG. 1, for convenience of illustration, the scan driver SDC is shown as a single component. However, an embodiment is not limited thereto. According to an embodiment, scan drivers may be included to supply a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may supply a light-emission signal to the emission lines ESL1 to ESLn based on a second control signal ECS. For example, the light-emission signal may be sequentially supplied to the emission lines ESL1 to ESLn.

Each of transistors connected to the emission lines ESL1 to ESLn may be embodied as an N-type transistor. In this regard, the light-emission signal supplied to the emission lines ESL1 to ESLn may be set to a gate-off voltage. The transistors may be turned off in case that the light-emission signal is supplied thereto. Otherwise, the transistors may be set to a turned-on state.

The second control signal ECS may include a light-emission start signal and clock signals. The emission driver EDC may be implemented as a shift register that sequentially shifts a pulse-type light-emission start signal using the clock signals to sequentially generate and output a pulse-type light-emission signal.

The data driver DDC may receive a third control signal DCS and image data RGB from the timing controller TC. The data driver DDC may convert the image data RGB in a form of a digital signal into an analog data signal (for example, a data signal). The data driver DDC may supply the data signal to the data lines DL1 to DLm in response to the third control signal DCS.

The third control signal DCS may include a data enable signal instructing output of a valid data signal, a horizontal start signal, a data clock signal, and the like within the scope of the disclosure. For example, the data driver DDC may include a shift register which shifts the horizontal start signal in synchronization with the data clock signal to generate a sampling signal, a latch that latches the image data RGB in response to the sampling signal, a digital-to-analog converter (or a decoder) that converts the latched image data (for example, the digital data) into analog data signals, and buffers (or amplifiers) that output the data signals to the data lines DL1 to DLm.

The power supply PWS may supply the first power voltage VDD, the second power voltage VSS, and the third power voltage VREF for operation of the pixel PXij to the display panel DP. Further, the power supply PWS may supply at least one voltage among the fourth power voltage VINT1, the fifth power voltage VINT2, and the sixth power voltage VCOMP to the display panel DP.

For example, the power supply PWS may supply, to the display panel DP, each of the first power voltage VDD, the second power voltage VSS, the third power voltage VREF, the fourth power voltage VINT1, the fifth power voltage VINT2, and the sixth power voltage VCOMP via each of a first power line VDL (FIG. 2A), a second power line VSL (FIG. 2A), a third power line (or a reference voltage line) VRL (FIG. 2A), a fourth power line (or a first initialization voltage line) VIL1 (FIG. 2A), a fifth power line (or a second initialization voltage line) VIL2 (FIG. 2A), and a sixth power line (or a compensation voltage line) VCL (FIG. 2A).

The power supply PWS may be implemented as a power management integrated circuit. However, this is an example, and an embodiment is not limited thereto.

The timing controller TC may generate the first control signal SCS, the second control signal ECS, the third control signal DCS, and a fourth control signal PCS, based on input image data IRGB, a synchronization signal Sync (for example, a vertical synchronization signal, a horizontal synchronization signal, etc.), a data enable signal DE, and a clock signal, etc. The first control signal SCS may be supplied to the scan driver SDC, and the second control signal ECS may be supplied to the emission driver EDC, the third control signal DCS may be supplied to the data driver DDC, and the fourth control signal PCS may be supplied to the power supply PWS. The timing controller TC may rearrange the input image data IRGB in correspondence with an arrangement of the pixel PXij in the display panel DP to generate the image data RGB (or a frame data).

In one example, the scan driver SDC, the emission driver EDC, the data driver DDC, the power supply PWS, and/or the timing controller TC may be directly formed on the display panel DP, or may be provided in a form of a separate driver chip and connected to the display panel DP. Further, at least two of the scan driver SDC, the emission driver EDC, the data driver DDC, the power supply PWS, or the timing controller TC may be provided as one driver chip. For example, the data driver DDC and the timing controller TC may be provided as one driver chip.

The display device DD has been described above with reference to FIG. 1. The display device of an embodiment is not limited thereto. Depending on a pixel configuration, additional signal lines may be added or omitted. Further, a connection relationship between one pixel and the signal lines may be changed. In case that one of the signal lines is omitted, another signal line may replace the omitted signal line.

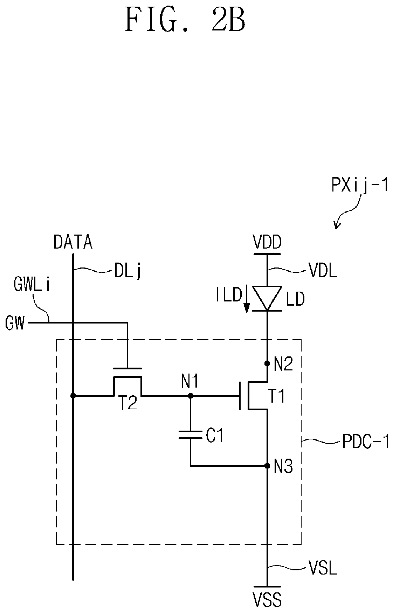

FIG. 2A and FIG. 2B respectively show schematic diagrams of equivalent circuit diagrams of pixels according to an embodiment. FIG. 2A and FIG. 2B respectively show schematic diagrams of equivalent circuit diagrams of pixels PXij and PXij-1 connected to the i-th first scan line GWLi (hereinafter, a first scan line) and connected to the j-th data line DLj (hereinafter, a data line) by way of example.

As shown in FIG. 2A, the pixel PXij may include the light emitting device LD and a pixel driver PDC. The light emitting device LD may be connected to a first power line VDL and the pixel driver PDC.

The pixel driver PDC may be connected to the scan lines GWLi, GCLi, GILi, GBLi, and GRLi, the data line DLj, the emission line ESLi, and the power voltage lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Hereinafter, a case in which each of the first to eighth transistors T1, T2, T3, T4, T5, T6, T7, and T8 is embodied as an N-type transistor is described by way of example. However, this is an example, and an embodiment is not limited thereto. Each of one or a number of the first to eighth transistors T1 to T8 may be an N-type transistor, while each of the others thereof may be a P-type transistor, or each of the first to eighth transistors T1 to T8 may be a P-type transistor. However, the disclosure is not limited to any one embodiment.

A gate of the first transistor T1 may be connected to a first node N1. A first electrode of the first transistor T1 may be connected to a second node N2 and a second electrode thereof may be connected to a third node N3. The first transistor T1 may be a driving transistor. The first transistor T1 may control a driving current ILD flowing from the first power line VDL to the second power line VSL via the light emitting device LD in response to a voltage of the first node N1. In this regard, the first power voltage VDD may be set to a voltage level having a higher potential than that of the second power voltage VSS.

The second transistor T2 may include a gate connected to the write scan line GWLi, a first electrode connected to the data line DLj, and a second electrode connected to the first node N1. The second transistor T2 may supply a data signal DATA to the first node N1 in response to a write scan signal GW transmitted via the write scan line GWLi. In case that the write scan signal GW is supplied to the write scan line GWLi, the second transistor T2 is turned on to electrically connect the data line DLj and the first node N1 to each other.

The third transistor T3 may be connected to and disposed between the first node N1 and the reference voltage line VRL. A first electrode of the third transistor T3 may receive the reference voltage VREF via the reference voltage line VRL, and a second electrode of the third transistor T3 may be connected to the first node N1. In an embodiment, a gate of the third transistor T3 may receive a reset scan signal GR via the i-th fifth scan line GRLi. In case that the reset scan signal GR is supplied to the reset scan line GRLi, the third transistor T3 may be turned on to provide the reference voltage VREF to the first node N1.

The fourth transistor T4 may be connected to and disposed between the third node N3 and the first initialization voltage line VIL1. A first electrode of the fourth transistor T4 may be connected to the third node N3, and a second electrode of the fourth transistor T4 may be connected to the first initialization voltage line VIL1 providing the first initialization voltage VINT1. The fourth transistor T4 may be referred to as a first initialization transistor. A gate of the fourth transistor T4 may receive a first initialization scan signal GI via the i-th third scan line GILi (hereinafter, a third scan line). In case that the first initialization scan signal GI is supplied to the first initialization scan line GILi, the fourth transistor T4 is turned on to supply the first initialization voltage VINT1 to the third node N3.

The fifth transistor T5 may be connected to and disposed between the compensation voltage line VCL and the second node N2. A first electrode of the fifth transistor T5 may receive the compensation voltage VCOMP via the compensation voltage line VCL, and a second electrode of the fifth transistor T5 may be connected to the second node N2 and thus may be electrically connected to the first electrode of the first transistor T1. A gate of the fifth transistor T5 may receive a compensation scan signal GC via the i-th second scan line GCLi (hereinafter, a second scan line). In case that the compensation scan signal GC is supplied to the compensation scan line GCLi, the fifth transistor T5 is turned on to provide the compensation voltage VCOMP to the second node N2, such that during a compensation period, a threshold voltage of the first transistor T1 may be compensated for.

The sixth transistor T6 may be connected to and disposed between the first transistor T1 and the light emitting device LD. By way of example, a gate of the sixth transistor T6 may receive a light-emission signal EM via the i-th emission line ESLi (hereinafter, a light-emission line). A first electrode of the sixth transistor T6 may be connected to a cathode of the light emitting device LD via a fourth node N4, and a second electrode of the sixth transistor T6 may be connected to the first electrode of the first transistor T1 via the second node N2. The sixth transistor T6 may be referred to as a first light-emission control transistor. In case that the light-emission signal EM is supplied to the emission line ESLi, the sixth transistor T6 is turned on to electrically connect the light emitting device LD and the first transistor T1 to each other.

The seventh transistor T7 may be connected to and disposed between the second power line VSL and the third node N3. A first electrode of the seventh transistor T7 may be connected to the second electrode of the first transistor T1 via the third node N3, and a second electrode of the seventh transistor T7 may receive the second power voltage VSS via the second power line VSL. A gate of the seventh transistor T7 may be electrically connected to the emission line ESLi. The seventh transistor T7 may be referred to as a second light-emission control transistor. In case that the light-emission signal EM is supplied to the emission line ESLi, the seventh transistor T7 is turned on to electrically connect the second electrode of the first transistor T1 and the second power line VSL to each other.

In FIG. 2A, it is illustrated that the sixth transistor T6 and the seventh transistor T7 are connected to the same emission line ESLi and are turned on based on the same light-emission signal EM. However, an embodiment is not limited thereto. For example, the sixth transistor T6 and the seventh transistor T7 may be independently turned on based on different signals. Further, one of the sixth transistor T6 and the seventh transistor T7 may be omitted.

The eighth transistor T8 may be connected to and disposed between the second initialization voltage line VIL2 and the fourth node N4. For example, the eighth transistor T8 may include a gate connected to the i-th fourth scan line GBLi (hereinafter, a fourth scan line), a first electrode connected to the second initialization voltage line VIL2, and a second electrode connected to the fourth node N4. The eighth transistor T8 may be referred to as a second initialization transistor. The eighth transistor T8 responds to a second initialization scan signal GB transmitted via the second initialization scan line GBLi to supply the second initialization voltage VINT2 to a cathode of the light emitting device LD and a corresponding fourth node N4. The cathode of the light emitting device LD may be initialized by the second initialization voltage VINT2.

In one example, some or a number of the second to eighth transistors T2, T3, T4, T5, T6, T7, and T8 may be simultaneously turned on based on the same scan signal. For example, the eighth transistor T8 and the fifth transistor T5 may be simultaneously turned on based on the same scan signal. For example, the eighth transistor T8 and the fifth transistor T5 may operate based on the same compensation scan signal GC. Because the eighth transistor T8 and the fifth transistor T5 are turned on/off based on the same compensation scan signal GC, the eighth transistor T8 and the fifth transistor T5 may be turned on/off at the same time. The compensation scan line GCLi and the second initialization scan line GBLi may be substantially provided as a single scan line. Accordingly, the initialization of the cathode of the light emitting device LD and the compensation for the threshold voltage of the first transistor T1 may be performed at the same time. However, this is an example, and the disclosure is not limited to any one embodiment.

Further, the initialization of the cathode of the light emitting device LD and the compensation for the threshold voltage of the first transistor T1 may be performed via application of the same power voltage. For example, the compensation voltage line VCL and the second initialization voltage line VIL2 may be substantially provided as a single power voltage line. The initialization operation of the cathode and the compensation operation for the threshold voltage of the driving transistor may be performed based on a single power voltage. Thus, a driver design may be simplified. However, this is an example, and the disclosure is not limited to any one embodiment.

The first capacitor C1 may be disposed between the first node N1 and the third node N3. The first capacitor C1 may store therein a difference between voltage levels of the first node N1 and the third node N3. The first capacitor C1 may be referred to as a storage capacitor.

The second capacitor C2 may be disposed between the third node N3 and the second power line VSL. For example, one electrode of the second capacitor C2 may be connected to the second power line VSL supplied with the second power voltage VSS, and the other electrode of the second capacitor C2 may be connected to the third node N3. The second capacitor C2 may store therein electric charges corresponding to a difference between voltage levels of the second power voltage VSS and the second node N2. The second capacitor C2 may be referred to as a hold capacitor. The second capacitor C2 may have a higher storage capacity than that of the first capacitor C1. Accordingly, the second capacitor C2 may minimize change in a voltage of the third node N3 in response to change in a voltage of the first node N1.

The light emitting device LD may be connected to the pixel driver PDC via the fourth node N4. The light emitting device LD may include an anode connected to the first power line VDL and the cathode opposite to the anode. The light emitting device LD may be connected to the pixel driver PDC via the cathode. For example, in the pixel PXij, a connection node where the light emitting device LD and the pixel driver PDC are connected to each other may be the fourth node N4, and the fourth node N4 may correspond to a connection node between the first electrode of the sixth transistor T6 and the cathode of the light emitting device LD.

Accordingly, a potential of the fourth node N4 may substantially correspond to a potential of the cathode of the light emitting device LD. By way of example, the anode of the light emitting device LD may be connected to the first power line VDL such that the first power voltage VDD as a constant voltage is applied thereto. The cathode thereof may be connected to the first transistor T1 via the sixth transistor T6. For example, in case that each of the first to eighth transistors T1 to T8 is an N-type transistor, an electric potential of the third node N3 corresponding to a source of the first transistor T1 as the driving transistor may not be directly affected by the characteristics of the light emitting device LD. Therefore, even in case that the light emitting device LD is deteriorated, an effect on a gate-source voltage of each of the transistors constituting the pixel driver PDC, for example, the driving transistor may be reduced. For example, an amount of change in the driving current due to deterioration of the light emitting device LD may be reduced, such that an afterimage defect of the display panel due to increase in a use time may be reduced, and a lifespan of the display panel may be improved.

By way of example, as shown in FIG. 2B, the pixel PXij-1 may include a pixel driver PDC-1 including two transistors T1 and T2 and one capacitor C1. The pixel driver PDC-1 may be connected to the light emitting device LD, the write scan line GWLi, the data line DLj, and the second power line VSL. The pixel driver PDC-1 as shown in FIG. 2B may correspond to a case in which the third to eighth transistors T3 to T8 and the second capacitor C2 may be omitted from the pixel driver PDC as shown in FIG. 2A.

Each of the first and second transistors T1 and T2 as shown in FIG. 2B may be N-type or P-type transistors. In an embodiment, an example in which each of the first and second transistors T1 and T2 is an N-type transistor is described.

The first transistor T1 may include a gate connected to the first node N1, a first electrode connected to the second node N2, and a second electrode connected to the third node N3. The second node N2 may be a node connected to the first power line VDL, and the third node N3 may be a node connected to the second power line VSL. The first transistor T1 may be connected to the light emitting device LD via the second node N2 and connected to the second power line VSL via the third node N3. The first transistor T1 may be a driving transistor.

The second transistor T2 may include a gate for receiving the write scan signal GW via the write scan line GWLi, a first electrode connected to the data line DLj, and a second electrode connected to the first node N1. The second transistor T2 may supply the data signal DATA to the first node N1 in response to the write scan signal GW transmitted via the write scan line GWLi.

The capacitor C1 may include an electrode connected to the first node N1 and an electrode connected to the third node N3. The capacitor C1 may store therein the data signal DATA transmitted to the first node N1.

The light emitting device LD may include an anode, a cathode, and a intermediate layer disposed between the anode and the cathode. By way of example, the anode of the light emitting device LD may be connected to the first power line VDL, and the cathode may be connected to the pixel driver PDC-1 via the second node N2. In an embodiment, the cathode of the light emitting device LD may be connected to the first transistor T1. The light emitting device LD may emit light in response to an amount of current flowing through the first transistor T1 of the pixel driver PDC-1.

In case that each of the first and second transistors T1 and T2 is an N-type transistor, the second node N2 at which the cathode of the light emitting device LD and the pixel driver PDC-1 are connected to each other may correspond to a drain of the first transistor T1. For example, a change in the gate-source voltage of the first transistor T1 caused by the light emitting device LD may be suppressed. Accordingly, an amount of change in the driving current due to deterioration of the light emitting device LD may be reduced, such that an afterimage defect of the display panel due to increase in a use time may be reduced and thus the lifespan thereof may be improved.

In one example FIG. 2A and FIG. 2B respectively show the pixel drivers PDC and PDC-1 according to an embodiment. As long as the pixel driver according to an embodiment is a circuit connected to the cathode of the light emitting device LD, the number and/or arrangement relationship of transistors thereof and the number and/or arrangement relationship of capacitors thereof may be designed in various ways. The disclosure is not limited to any one embodiment.

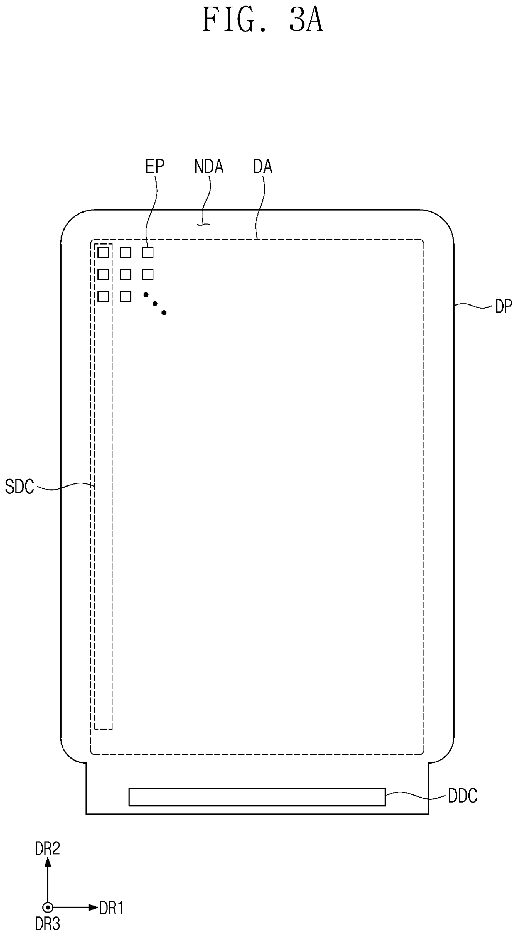

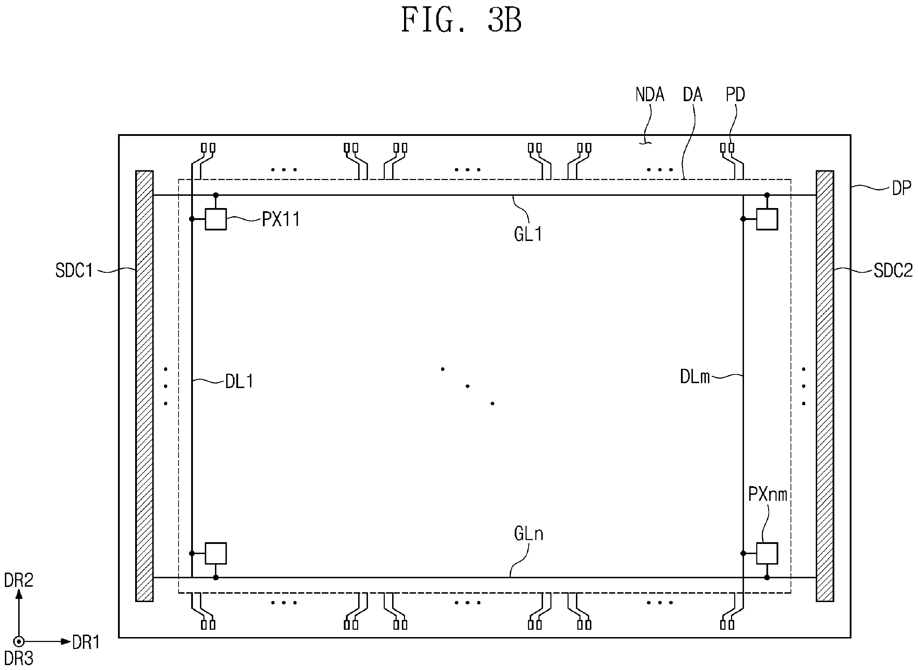

FIG. 3A and FIG. 3B are schematic plan views briefly showing a display device according to an embodiment, and some or a number of components may be omitted in FIG. 3A and FIG. 3B. Referring to FIG. 3A, the display panel DP of an embodiment may be divided into a display area DA and a peripheral area (or a non-display area) NDA. The display area DA may include emitting parts EP.

FIG. 3A and following drawings show a first direction axis DR1 to a third direction axis DR3. Directions indicated by the first to third direction axes DR1, DR2, and DR3 as described herein are relative concepts and may be converted to other directions. The directions indicated by the first to third direction axes DR1, DR2, and DR3 may be referred to as first to third directions, respectively. The same reference numbers may be used for the first to third directions. As used herein, the first direction axis DR1 and the second direction axis DR2 may be orthogonal to each other, and the third direction axis DR3 may be a normal direction to a plane defined by the first direction axis DR1 and the second direction axis DR2.

A thickness direction of the display device DD may be a direction parallel to the third direction axis DR3 which is the normal direction to the plane defined by the first direction axis DR1 and the second direction axis DR2. As used herein, a front face (or a top face) and a rear face (or a bottom face) of each of members constituting the display device DD may be defined in the third direction axis DR3. As used herein, "a plan view" means a view toward the plane defined by the first direction axis DR1 and the second direction axis, and "a cross-sectional view" means a view of a cross-section perpendicular to the plane and parallel to the third direction axis DR3.

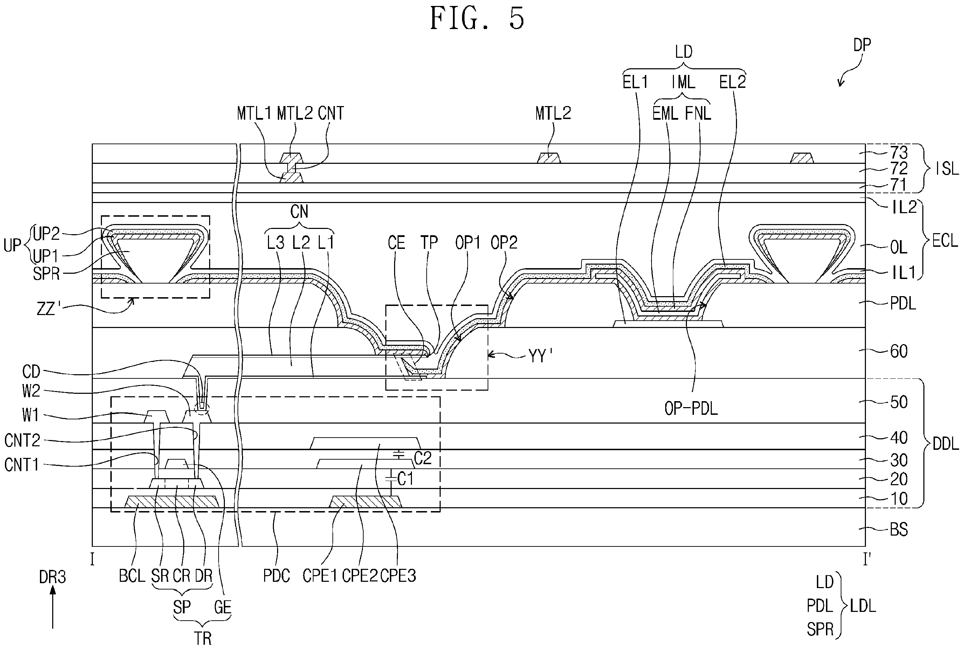

The emitting parts EP may be respective areas of the pixels PXij (FIG. 1) to emit light. By way of example, each of the emitting parts EP may correspond to a light-emitting opening OP-PDL (FIG. 5) as described later.

The peripheral area NDA may be adjacent to the display area DA. In FIG. 3A, the peripheral area NDA is shown as having a shape surrounding an edge of the display area DA. However, this is shown by way of example, and the peripheral area NDA may be disposed on one side or a side of the non-display area NDA or may be omitted. The disclosure is not limited to any one embodiment.

In an embodiment, the scan driver SDC and the data driver DDC may be mounted in the display panel DP. In an embodiment, the scan driver SDC may be disposed in the display area DA, and the data driver DDC may be disposed in the peripheral area NDA. The scan driver SDC may overlap at least some or a number of the emitting parts EP disposed in the display area DA in a plan view. As the scan driver SDC is disposed in the display area DA, an area size of the peripheral area NDA of the display panel DP of an embodiment may be reduced compared to that in other display panels in which the scan driver is disposed in the peripheral area. Thus, a display device with a thin bezel may be readily implemented. As used herein, one component overlapping another component is not limited to a configuration that one component and another component have the same area and the same shape in a plan view, and may include a configuration that one component and another component have different areas and different shapes in a plan view.

Unlike what is shown in FIG. 3A, the scan driver SDC may be provided as two separate circuits. The two scan driver circuits SDC may be spaced apart from each other and may be respectively disposed in left and right sides of the display area DA while a center thereof is interposed therebetween. By way of example, the number of the scan drivers SDC may be three or greater. The disclosure is not limited to any one embodiment.

In one example, unlike what is shown in FIG. 3A, the data driver DDC may be disposed in the display area DA. In this regard, some or a number of the emitting parts EP disposed in the display area DA may overlap the data driver DDC in a plan view.

The data driver DDC may be provided in a form of a separate driver chip independent of the display panel DP and may be connected to the display panel DP. However, this is an example, and the data driver DDC and the scan driver SDC may be formed in the same process to constitute the display panel DP. The disclosure is not limited to any one embodiment.

As shown in FIG. 3B, the display panel DP may have a length in the first direction DR1 larger than a length in the second direction DR2. The display panel DP may include scan drivers SDC1 and SDC2. The scan drivers SDC1 and SDC2 are illustrated as including a first scan driver SDC1 and a second scan driver SDC2 spaced apart from each other in the first direction DR1.

The first scan driver SDC1 may be connected to one or a number of scan lines GL1 to GLn and the second scan driver SDC2 may be connected to the others of scan lines GL1 to GLn. For example, the first scan driver SDC1 may be connected to odd scan lines among the scan lines GL1 to GLn, and the second scan driver SDC2 may be connected to even scan lines among the scan lines GL1 to GLn.

FIG. 3B shows pads PD of the data lines DL1 to DLm for convenience of illustration. The pads PD may be respectively defined at ends of the data lines DL1 to DLm. The data lines DL1 to DLm may be connected to the data driver DDC (FIG. 3A) via the pads PD.

The pads PD may be divided into two groups disposed in the peripheral area NDA and spaced apart from each other while the display area DA is interposed therebetween. For example, one or a number of the pads PD may be disposed in an upper area, for example, in an area adjacent to the first scan line GL1 among the scan lines GL1 to GLn, and the others of the pads PD may be disposed in a lower area, for example, an area adjacent to the last scan line GLn among the scan lines GL1 to GLn. In an embodiment, the pads PD connected to odd data lines among the pads PD may be disposed in the upper area, and the pads PD connected to even data lines among the pads PD may be disposed in the lower area.

Although not shown, the display panel DP may include upper data drivers respectively connected to the pads PD disposed in the upper area and/or lower data drivers respectively connected to the pads PD disposed in the lower area. However, this is an example, and the display panel DP may include one upper data driver connected to the pads PD disposed in the upper area and/or one lower data driver connected to the pads PD disposed in the lower area. For example, the pads PD may be disposed in one area and may be connected to a single data driver. The disclosure is not limited to any one embodiment.

Further, as described above in FIG. 3A, the display panel DP in FIG. 3B may include a scan driver and/or a data driver disposed in the display area DA, and accordingly, some or a number of the emitting parts disposed in the display area DA may overlap the scan driver and/or the data driver in a plan view.

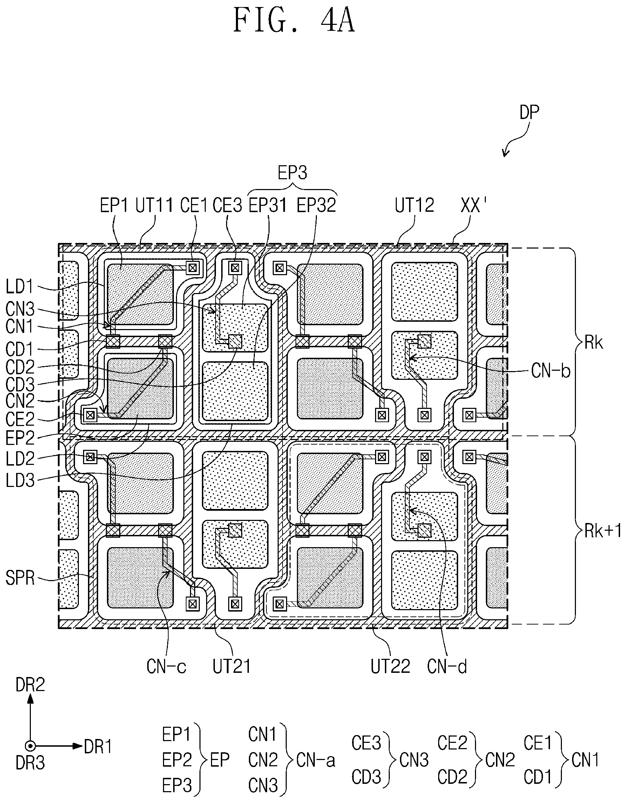

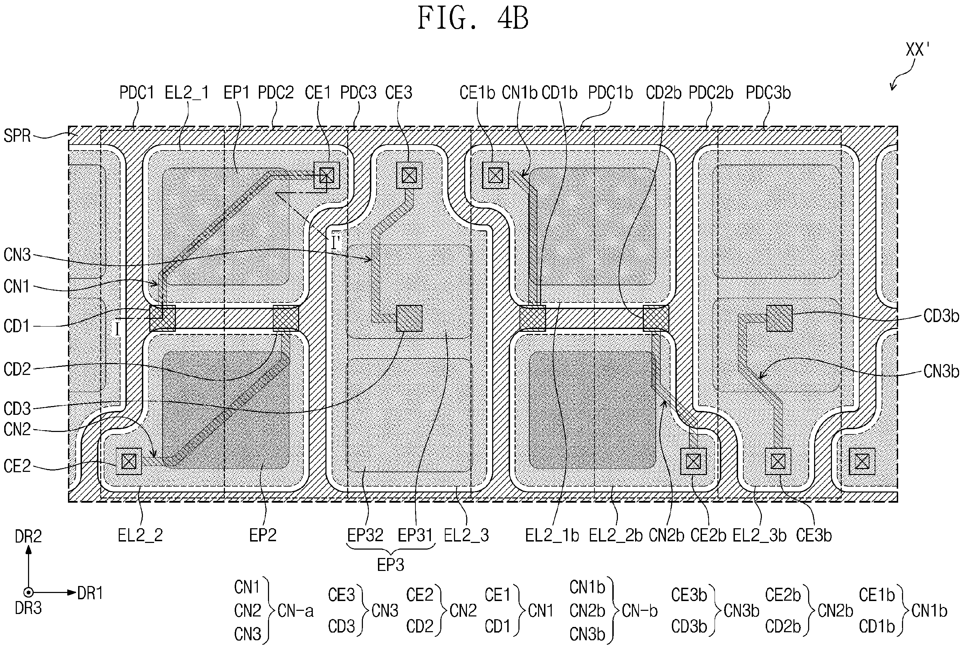

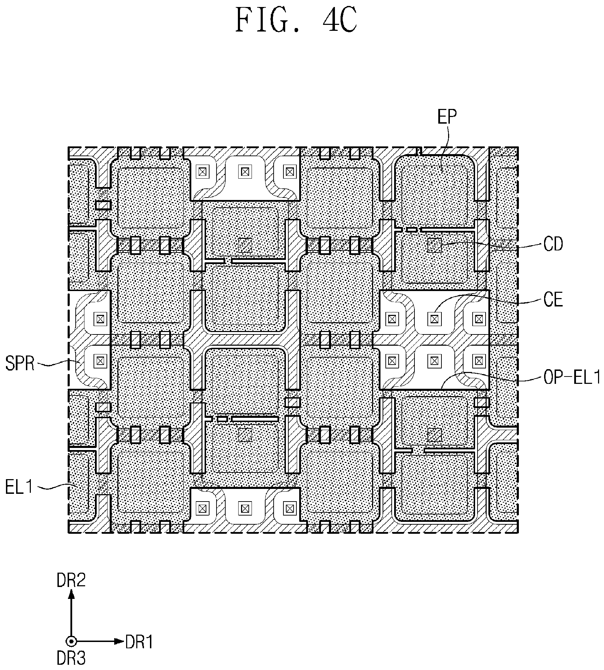

FIG. 4A to FIG. 4C are enlarged schematic plan views of a partial area of the display panel DP according to an embodiment. FIG. 4A shows an area where four light emitting units UT11, UT12, UT21, and UT22 are arranged or disposed in 2 rows and 2 columns, and FIG. 4B shows an enlarged view of an area XX' as shown in FIG. 4A. In FIG. 4C, some or a number of components among components as shown in FIG. 4A may be omitted or emphasized.

Referring to FIG. 4A, emitting parts of a first row Rk may include emitting parts constituting a first row first column light emitting unit UT11 and a first row second column light emitting unit UT12. Emitting parts of a second row Rk+1 may include emitting parts constituting a second row first column light emitting unit UT21 and a second row second column light emitting unit UT22. In FIG. 4A and FIG. 4B, a separator SPR, emitting parts EP disposed in an area defined by the separator SPR, connection wirings CN-a and CN-b, and second electrodes EL2_1, EL2_1b, EL2_2, EL2_2b, EL2_3, and EL2_3b among components of the display panel DP are shown. The separator SPR may be referred to as an isolation structure.

As described above, each of the emitting parts EP may correspond to the light-emitting opening OP-PDL (FIG. 5) as described later. For example, each of the emitting parts EP may be an area in which the above-described light emitting device LD (FIG. 2A and FIG. 2B) emits light, and may correspond to a unit generating an image displayed on the display panel DP. By way of example, each of the emitting parts EP may correspond to an area defined by the light-emitting opening OP-PDL (FIG. 5) as described later, that may be an area defined by a bottom face of the light-emitting opening OP-PDL.

The emitting parts EP may include a first emitting part EP1, a second emitting part EP2, and a third emitting part EP3. The first emitting part EP1, the second emitting part EP2, and the third emitting part EP3 may display light of different colors. For example, the first emitting part EP1 may emit red light, the second emitting part EP2 may emit green light, and the third emitting part EP3 may emit blue light. However, the disclosure is not limited thereto. At least two of the emitting parts EP may emit light of the same color. For example, all of the first to third emitting parts EP1, EP2, and EP3 may emit blue light or may emit white light.

In one example, the third emitting part EP3 emitting light emitted from a third light emitting device LD3 among the emitting parts EP may include two sub-emitting parts EP31 and EP32 spaced apart from each other in the second direction DR2. However, this is shown by way of example, and the third emitting part EP3 may be provided as one pattern having an integral structure as in each of the first and second emitting parts EP1 and EP2. At least one of the first and second emitting parts EP1 and EP2 may include sub-emitting parts. The disclosure is not limited to any one embodiment.

The emitting parts of the first row Rk may constitute the first row first column light emitting units UT11 and the first row second column light emitting units UT12 which are repeatedly arranged or disposed. The emitting parts of the second row Rk+1 may constitute the second row first column light emitting units UT21 and the second row second column light emitting units UT22 which are repeatedly arranged or disposed. In this regard, the emitting parts constituting the first row first column light emitting unit UT11 and the emitting parts constituting the second row first column light emitting unit UT21 may be arranged or disposed in a symmetric manner with each other in an axis parallel to the first direction DR1. The emitting parts constituting the first row second column light emitting unit UT12 and the emitting parts constituting the second row second column light emitting unit UT22 may be arranged or disposed in a symmetric manner with each other in an axis parallel to the first direction DR1. Further, connection parts of connection wirings CN-a connected to the first row first column light emitting unit UT11 and connection parts of connection wirings CN-c connected to the second row first column light emitting unit UT21 may be arranged or disposed in a symmetric manner with each other in an axis parallel to the first direction DR1. Further, connection parts of connection wirings CN-b connected to the first row second column light emitting unit UT12 and connection parts of connection wirings CN-d connected to the second row second column light emitting unit UT22 may be arranged or disposed in a symmetric manner with each other in an axis parallel to the first direction DR1.

For example, each of the light emitting units UT11, UT12, UT21, and UT22 may include three emitting parts EP1, EP2, and EP3. Each of the light emitting units UT11, UT12, UT21, and UT22 may include three second electrodes, three pixel drivers, and three connection wirings. However, this is shown by way of example, and the number and arrangement of the emitting parts in each of the light emitting units UT11, UT12, UT21, and UT22 may be designed in various ways. The disclosure is not limited to any one embodiment.

FIG. 4B is an enlarged view of the first row first column light emitting unit UT11 and the first row second column light emitting unit UT12 as shown in FIG. 4A. In FIG. 4B, for convenience of illustration, second electrodes EL2_1, EL2_1b, EL2_2, EL2_2b, EL2_3, and EL2_3b, pixel drivers PDC1, PDC1b, PDC2, PDC2b, PDC3, and PDC3b, and connection wirings CN-a, and CN-b are shown. The second electrodes EL2_1, EL2_2, and EL2_3 (hereinafter, first to third cathodes) may be distinguished from each other via the separator SPR.

Hereinafter, the first row first column light emitting unit UT11 will be described in detail with reference to FIG. 4A and FIG. 4B. Each of the first to third pixel drivers PDC1, PDC2, and PDC3 may be electrically connected to each of the first to third light emitting devices LD1, LD2, and LD3 (FIG. 4A) of the first to third emitting parts EP1, EP2, and EP3. The first to third light emitting devices LD1, LD2, and LD3 (FIG. 4A) may include the first to third cathodes EL2_1, EL2_2, and EL2_3, respectively. As used herein, "A is connected to B" includes a case in which A is physically directly connected to B and a case in which A is electrically connected to B.

Further, as shown in FIG. 4B, an area of each of the pixel drivers PDC1, PDC2, and PDC3 in a plan view may correspond to a unit in which transistor and capacitor elements constituting the pixel driver PDC (FIG. 2A) for driving a light emitting device of a pixel are repeatedly arranged or disposed.

The first to third pixel drivers PDC1, PDC2, and PDC3 may be sequentially arranged or disposed along the first direction DR1. In one example, positions of the first to third pixel drivers PDC1, PDC2, and PDC3 may be independently designed regardless of positions and/or area shapes of the first to third emitting parts EP1, EP2, and EP3.

For example, each of the first to third pixel drivers PDC1, PDC2, and PDC3 may be disposed in a different location from each of areas defined by the separators SPR, for example, from each of positions where the first to third cathodes EL2_1, EL2_2, and EL2_3 are positioned. Each of the first to third pixel drivers PDC1, PDC2, and PDC3 may be designed to have an area shape different from that of each of the first to third cathodes EL2_1, EL2_2, and EL2_3. By way of example, each of the first to third pixel drivers PDC1, PDC2, and PDC3 may be positioned so as to overlap each of the areas in which the first to third emitting parts EP1, EP2, and EP3 are positioned. Each of the first to third pixel drivers PDC1, PDC2, and PDC3 may be designed to have an area shape similar to a shape of each of areas defined by the separator SPR, for example, an area shape of each of the first to third cathodes EL2_1, EL2_2, and EL2_3.

In an embodiment, each of the first to third pixel drivers PDC1, PDC2, and PDC3 is shown as having a rectangular shape, and each of the first to third emitting parts EP1, EP2, and EP3 is shown as having a smaller area than an area of the rectangular shape and a different shape from the rectangular shape. Further, each of the first to third cathodes EL2_1, EL2_2, and EL2_3 is illustrated as being positioned so as to overlap each of the first to third emitting parts EP1, EP2, and EP3, respectively, and is shown as having an irregular shape.

Accordingly, as shown in FIG. 4B, the first pixel driver PDC1 may be positioned so as to partially overlap the first emitting part EP1, the second emitting part EP2, and another light emitting unit adjacent thereto. The second pixel driver PDC2 may be positioned so as to partially overlap the first emitting part EP1, the second emitting part EP2, and the third emitting part EP3. The third pixel driver PDC3 may be positioned so as to partially overlap the third emitting part EP3. In some examples, the position of each of the first to third pixel drivers PDC1, PDC2, and PDC3 may be designed in various manners independently of the first to third emitting parts EP1, EP2, and EP3. The disclosure is not limited to any one embodiment.

The connection wiring CN-a may include connection wirings which may be spaced apart from each other. Each of the connection wirings CN-a may connect each of the first to third pixel drivers PDC1, PDC2, and PDC3 to each of the first to third light emitting devices LD1, LD2, and LD3 (FIG. 4A). By way of example, each connection wiring CN-a may correspond to a node (N4 in FIG. 2A or N2 in FIG. 2B) where the light emitting device LD is connected to the pixel driver PDC or PDC-1.

The connection wirings CN-a may include emission connection parts CE1, CE2, and CE3 and driver connection parts CD1, CD2, and CD3. Each of the emission connection parts CE1, CE2, and CE3 may be provided at one end of each of the connection wirings CN-a while each of the driver connection parts CD1, CD2, and CD3 may be provided at the other end of each of the connection wirings CN-a.

Each of the driver connection parts CD1, CD2, and CD3 may refer to a portion of each of the connection wirings CN-a connected to each of the pixel drivers PDC1, PDC2, and PDC3. In an embodiment, each of the driver connection parts CD1, CD2, and CD3 may be connected to a drain of the sixth transistor T6 as shown in FIG. 2A or a drain of the first transistor T1 as shown in FIG. 2B. Accordingly, a location of each of the driver connection parts CD1, CD2, and CD3 may correspond to a location of a transistor TR (FIG. 5) of each of the pixel drivers PDC1, PDC2, and PDC3 physically connected to each of the connection wirings CN-a. Each of the emission connection parts CE1, CE2, and CE3 may refer to a portion of each of the connection wirings CN-a connected to each of the light emitting devices. In an embodiment, each of the emission connection parts CE1, CE2, and CE3 may be connected to each of the cathodes EL2_1, EL2_2, and EL2_3 of the light emitting devices LD1, LD2, and LD3 (FIG. 4A).

The light emitting unit UT11 may include the first to third connection wirings CN1, CN2, and CN3. The first connection wiring CN1 may connect the first light emitting device LD1 constituting the first emitting part EP1 to the first pixel driver PDC1. The second connection wiring CN2 may connect the second light emitting device LD2 constituting the second emitting part EP2 to the second pixel driver PDC2. The third connection wiring CN3 may connect the third light emitting device LD3 constituting the third emitting part EP3 to the third pixel driver PDC3.

By way of example, the first to third connection wirings CN1, CN2, and CN3 may connect the first to third cathodes EL2_1, EL2_2, and EL2_3 to the first to third pixel drivers PDC1, PDC2, and PDC3, respectively. The first connection wiring CN1 may include the first driver connection part CD1 connected to the first pixel driver PDC1 and the first emission connection part CE1 connected to the first cathode EL2_1. The second connection wiring CN2 may include the second driver connection part CD2 connected to the second pixel driver PDC2 and the second emission connection part CE2 connected to the second cathode EL2_2. The third connection wiring CN3 may include the third driver connection part CD3 connected to the third pixel driver PDC3 and the third emission connection part CE3 connected to the third cathode EL2_3.

The first to third driver connection parts CD1, CD2, and CD3 may be aligned along the first direction DR1. As described above, the positions of the first to third driver connection parts CD1, CD2, and CD3 may respectively correspond to positions of connection transistors constituting the first to third pixel drivers PDC1, PDC2, and PDC3, respectively. The connection transistor may be a transistor including a connection node at which a pixel driver and a light emitting device in one pixel are connected to each other as one electrode. For example, a position of the connection transistor may correspond to a position of the sixth transistor T6 in FIG. 2A or the first transistor T1 in FIG. 2B. According to an embodiment, regardless of a shape, a size, or a light-emitting color of each of the emitting parts EP1, EP2, and EP3, a shape, a position, and an arrangement of each of the pixel drivers of all pixels may be designed in a simple manner.

In an embodiment, the first to third emission connection parts CE1, CE2, and CE3 may be respectively disposed at non-overlapping positions with the emitting parts EP1, EP2, and EP3 in a plan view. Each of the first to third emission connection parts CE1, CE2, and CE3 may refer to a portion of each of the connection wirings CN-a connected to each of the first to third light emitting devices LD1, LD2, and LD3 (FIG. 4A). Further, each of the first to third emission connection parts CE1, CE2, and CE3 belongs to an area in which a tip part TP (FIG. 5) as described below is defined. Thus, each of the first to third emission connection parts CE1, CE2, and CE3 does not overlap the light-emitting opening OP-PDL (FIG. 5). For example, each of the first to third emission connection parts CE1, CE2, and CE3 may be located or disposed at a position in each of the first to third cathodes EL2_1, EL2_2, and EL2_3 so as to be spaced from each of the first to third emitting parts EP1, EP2, and EP3. Each of the first to third cathodes EL2_1, EL2_2, and EL2_3 may include a partial area protruding from each of the emitting parts EP1, EP2, and EP3 in the plan view such that each of the first to third cathodes EL2_1, EL2_2, and EL2_3 is connected to each of the connection wirings CN-a at each location where each of the first to third emission connection parts CE1, CE2, and CE3 is disposed.

For example, the first cathode EL2_1 may include a protrusion protruding from the first emitting part EP1 at a position that does not overlap the first emitting part EP1 such that the first emission connection part CE1 is disposed in the protrusion. The first pixel driver PDC1, for example, the first driver connection part CD1 at which the first connection wiring CN1 is connected to the transistor TR (FIG. 5) may be defined at a location that does not overlap the first emitting part EP1 in the plan view. According to an embodiment, the first connection wiring CN1 may be disposed in the first emitting part EP1, so that the first cathode EL2_1 and the first pixel driver PDC1 spaced apart from each other may be readily connected to each other.

The third pixel driver PDC3, for example, the third driver connection part CD3 contacting the connection transistor TR may be defined at a position that does not overlap the third emission connection part CE3 in a plan view, and may be disposed at an overlapping position with the third emitting part EP3. According to an embodiment, the third cathode EL2_3 and the third pixel driver PDC3 may be connected to each other via the third connection wiring CN3. Thus, in a design of the third pixel driver PDC3, limitation in terms of a location or a shape of the third emitting part EP3 may be reduced, so that a degree of freedom of design may be improved.

The above description about the first row first column light emitting unit UT11 may be equally applied to the first row second column light emitting unit UT12. For example, the above description about each of the first to third pixel drivers PDC1, PDC2, and PDC3, the first to third cathodes EL2_1, EL2_2, and EL2_3, and the first to third connection wirings CN1, CN2 and CN3 of the first row first column light emitting unit UT11 may be equally applied to each of the first to third pixel drivers PDC1b, PDC2b, and PDC3b, the first to third cathodes EL2_1b, EL2_2b, EL2_3b, and the first to third connection wirings CN1b, CN2b, and CN3b of the first row second column light emitting unit UT12. The above description about the emission connection parts CE1, CE2, and CE3 and the driver connection parts CD1, CD2, and CD3 included in the first to third connection wirings CN1, CN2 and CN3 of the first row first column light emitting unit UT11 may be equally applied to emission connection parts CE1b, CE2b, and CE3b and the driver connection parts CD1b, CD2b, and CD3b included in the first to third connection wirings CN1b, CN2b and CN3b of the first row second column light emitting unit UT12.

Referring to FIG. 4A, the emitting parts of the second row Rk+1 may constitute the second row first column light emitting units UT21 and the second row second column light emitting units UT22 which are repeatedly arranged or disposed. In this regard, the emitting parts constituting the first row first column light emitting unit UT11 and the emitting parts constituting the second row first column light emitting unit UT21 may be arranged or disposed in a symmetric manner with each other in an axis parallel to the second direction DR2. The emitting parts constituting the first row second column light emitting unit UT12 and the emitting parts constituting the second row second column light emitting unit UT22 may be arranged or disposed in a symmetric manner with each other in an axis parallel to the second direction DR2. Thus, each of the light emitting units UT21 and UT22 of the second row may be composed of emitting parts to which the emitting parts of each of the first row light emitting units UT11 and UT12 are substantially shifted in the second direction DR2. For example, the second row first column light emitting unit UT21 may be composed of emitting parts having the same shapes respectively as those of the emitting parts of the first row second column light emitting unit UT12. The second row second column light emitting unit UT22 may be composed of emitting parts having the same shapes respectively as those of the emitting parts of the first row first column light emitting unit UT11.

Accordingly, the shapes and arrangement of the connection wirings CN-c connected to the second row first column light emitting unit UT21 may be the same as the shapes and arrangement of the connection wirings CN-b connected to the first row second column light emitting unit UT12. Similarly, the shapes and arrangement of the connection wirings CN-d connected to the second row second column light emitting unit UT22 may be the same as the shapes and arrangement of the connection wirings CN-a connected to the first row first column light emitting unit UT11. In FIG. 4C and subsequent drawings, the connection wiring is referred to as CN, the driver connection part is referred to as CD, and the emission connection part is referred to as CE for convenience of description. The above description about the connection wiring CN may be equally applied to each of the connection wirings CN-a, CN-b, CN-c, and CN-d of the first to fourth light emitting units UT11, UT12, UT21, and UT22. The above description about the driver connection part CD may be equally applied to each of the driver connection parts of the connection wirings CN-a, CN-b, CN-c, and CN-d as aforementioned. The above description of the emission connection part CE may be equally applied to each of the emission connection parts of the connection wirings CN-a, CN-b, CN-c, and CN-d as above-described.

Referring to FIG. 4C, the first electrode EL1 according to an embodiment may commonly belong to emitting parts EP. The first to third light emitting devices LD1, LD2, and LD3 (FIG. 4A) may include the first electrode EL1. The first electrode EL1 may be formed as a single layer extending in an integral manner across an entirety of the display area DA, and accordingly, the first electrode EL1 may overlap the separator SPR. By way of example, the first electrodes EL1 of the first to third light emitting devices LD1, LD2, and LD3 (FIG. 4A) may be respectively formed as independent conductive patterns spaced apart from each other, and may be electrically connected to each other via another conductive layer. Accordingly, anode first electrode EL1 patterns may be positioned in a non-overlapping manner with the separator SPR.

The first electrode EL1 may be an anode. As described above, the first power voltage VDD may be applied to the anode EL1 and a common voltage may be provided to all of the emitting parts EP. The anode EL1 may be connected to the first power line VDL (FIG. 2A) providing the first power voltage VDD in the peripheral area NDA or may be connected to the first power line VDL in the display area DA. The disclosure is not limited to any one embodiment.

In one example, openings OP-EL1 may be defined in the anode EL1. The openings OP-EL1 may extend through the anode EL1. The openings OP-EL1 may non-overlap the emitting parts EP. In general, the openings OP-EL1 may be defined so as to overlap the separator SPR. The openings OP-EL1 may facilitate discharge of gas generated from an organic layer disposed below the anode EL1, for example, from a sixth insulating layer 60 (FIG. 5) to be described later. Accordingly, in a display panel manufacturing process, the gas from the organic layer disposed below the light emitting device may be sufficiently discharged. Thus, an amount of the gas discharged from the organic layer after the manufacturing process may be reduced to lower a deterioration speed of the light emitting device.

According to an embodiment, the connection wiring may be disposed between the light emitting device and the pixel driver. Thus, even in case that only a cathode shape is changed without changing an arrangement or shapes of the emitting parts, the light emitting device may be readily connected to the pixel driver. Accordingly, a design freedom in terms of an arrangement of the pixel drivers may be improved, and an area of the emitting part or a resolution of the display panel may be readily increased.

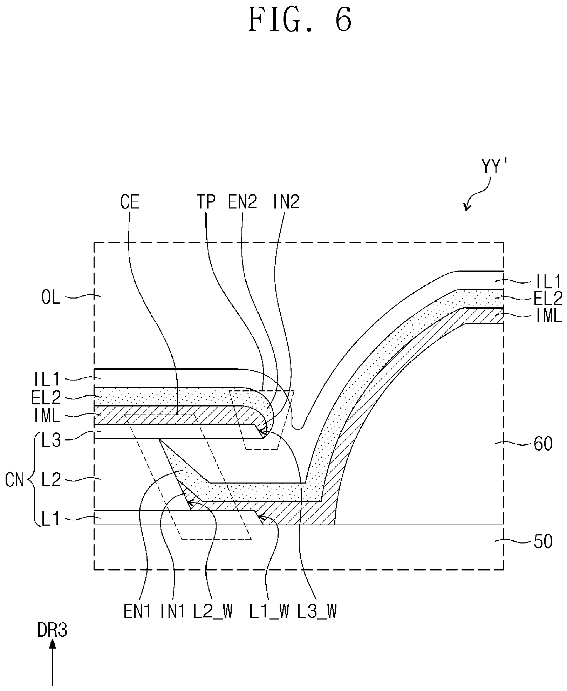

FIG. 5 is a schematic cross-sectional view of a display panel according to an embodiment. FIG. 5 is a schematic cross-sectional view showing a portion corresponding to line I-I' in FIG. 4B. FIG. 6 is an enlarged view of an area YY' of FIG. 5, and is a schematic cross-sectional view showing a partial area of a display panel according to an embodiment.

Referring to FIG. 5, the display panel DP of an embodiment may include a base layer BS, a driving device layer DDL disposed on the base layer BS, a light emitting device layer LDL disposed on the driving device layer DDL, and a sensing layer ISL disposed on the light emitting device layer LDL. The driving device layer DDL may include insulating layers 10, 20, 30, 40, and 50, and conductive patterns and semiconductor patterns disposed between the insulating layers. The conductive patterns and the semiconductor patterns may be disposed between the insulating layers so as to constitute the pixel driver PDC and the light emitting device LD. FIG. 5 shows a cross-section of a portion of an area in which one of the first to third emitting parts EP1, EP2, and EP3 is disposed for convenience of illustration.

The base layer BS may be a member providing a base face on which the pixel driver PDC is disposed. The base layer BS may be a rigid substrate or a flexible substrate capable of being bent, folded, or rolled. The base layer BS may be a glass substrate, a metal substrate, or a polymer substrate. However, an embodiment is not limited thereto, and the base layer BS may be an inorganic layer, an organic layer, or a composite material layer.

The base layer BS may have a multi-layer structure. The base layer BS may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

Each of the first and second polymer resin layers may include a polyimide-based resin. Further, each of the first and second polymer resin layers may include at least one of acrylate-based resin, methacrylate-based resin, polyisoprene-based resin, vinyl-based resin, epoxy-based resin, urethane-based resin, cellulose-based resin, siloxane-based resin, polyamide-based resin, or perylene-based resin. As used herein, "~based" resin means a resin including a functional group of "~".

Each of the insulating layers or the conductive layers and the semiconductor layers disposed on the base layer BS may be formed using a scheme such as coating or deposition. Thereafter, the organic layer, the inorganic layer, the semiconductor layer, and the conductive layer may be selectively patterned using photolithography processes to form a hole in the insulating layer or to form the semiconductor pattern, the conductive pattern, and a signal line.

The driving device layer DDL may include the first to fifth insulating layers 10, 20, 30, 40, and 50 sequentially stacked on each other on the base layer BS and the pixel driver PDC. FIG. 5 shows one transistor TR and two capacitors C1 and C2 of the pixel driver PDC. The transistor TR may correspond to a transistor connected to the light emitting device LD via the connection wiring CN, for example, the connection transistor connected to the node (N4 in FIG. 2A or N2 in FIG. 2B) corresponding to the cathode of the light emitting device LD. By way of example, the transistor TR may correspond to the sixth transistor T6 of FIG. 2A or the first transistor T1 of FIG. 2B. Although not shown, each of other transistors constituting the pixel driver PDC may have the same structure as that of the transistor TR (hereinafter, the connection transistor) as shown in FIG. 5. However, this is described by way of example, and each of the other transistors constituting the pixel driver PDC may have a structure different from that of the connection transistor TR. The disclosure is not limited to any one embodiment.

The first insulating layer 10 may be disposed on the base layer BS. The first insulating layer 10 may be an inorganic layer and/or an organic layer, and may have a single-layer or multi-layer structure. The first insulating layer 10 may include at least one of aluminum oxide, titanium oxide, silicon oxide, silicon nitride, silicon oxynitride, zirconium oxide, or hafnium oxide. For example, the first insulating layer 10 may be a single layer made of silicon oxide. Each of the insulating layers as described later may be an inorganic layer and/or an organic layer and may have a single-layer or multi-layer structure. The inorganic layer may include at least one of the above materials. However, the disclosure is not limited thereto.

In one example, the first insulating layer 10 may cover a bottom conductive layer BCL. For example, the display panel DP may further include the bottom conductive layer BCL disposed to overlap the connection transistor TR. The bottom conductive layer BCL may prevent an electric potential due to a polarization phenomenon of the base layer BS from affecting the connection transistor TR. Further, the bottom conductive layer BCL may prevent light incident from a position below the bottom conductive layer BCL from being incident to the connection transistor TR. At least one of an inorganic barrier layer and a buffer layer may be further disposed between the bottom conductive layer BCL and the base layer BS.

The bottom conductive layer BCL may include a reflective metal. For example, the bottom conductive layer BCL may include titanium (Ti), molybdenum (Mo), an alloy containing molybdenum, aluminum (Al), an alloy containing aluminum, aluminum nitride (AlN), tungsten (W), tungsten nitride (WN), or copper (Cu).

The bottom conductive layer BCL may be connected to a wiring via a contact electrode (not shown), and may receive a constant voltage or a pulse signal therefrom. In an embodiment, the bottom conductive layer BCL may be provided in an isolated form from other electrodes or the wiring. However, this is an example, and the bottom conductive layer BCL may be provided in various forms. The disclosure is not limited to any one embodiment.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. For example, an oxide semiconductor may include a transparent conductive oxide (TCO) such as indium tin oxide (ITO), indium zinc oxide (IZO), indium gallium zinc oxide (IGZO), zinc oxide (ZnO) or indium oxide (In₂O₃). However, the disclosure is not limited thereto, and the semiconductor pattern may include amorphous silicon, low-temperature polycrystalline silicon, or polycrystalline silicon.

The semiconductor pattern SP may include a source area SR, a drain area DR, and a channel area CR (or a channel) distinguished from each other based on a conductivity level. The channel area CR may be a portion overlapping the gate electrode GE in a plan view. The source area SR and the drain area DR may be spaced apart while the channel area CR is interposed therebetween. In case that the semiconductor pattern SP is made of an oxide semiconductor, each of the source area SR and the drain area DR may be a reduced area. Accordingly, each of the source area SR and the drain area DR has a relatively high content of a reduced metal compared to that in the channel area CR. By way of example, in case that the semiconductor pattern SP is made of polycrystalline silicon, each of the source area SR and the drain area DR may be an area doped with impurities at a high concentration.

Each of the source area SR and the drain area DR may have relatively higher conductivity than that of the channel area CR. The source area SR may correspond to the source electrode of the connection transistor TR and the drain area DR may correspond to the drain electrode of the connection transistor TR. As shown in FIG. 5, a separate source electrode pattern W1 and a separate drain electrode pattern W2 respectively connected to the source area SR and the drain area DR may be further provided. By way of example, each of the separate source electrode pattern W1 and the separate drain electrode pattern W2 may be integral with one of lines constituting the pixel driver (FIG. 2A and FIG. 2B). The disclosure is not limited to any one embodiment.

The second insulating layer 20 may commonly overlap the pixels PX11 to PXnm and may cover the semiconductor pattern SP. The second insulating layer 20 may be an inorganic layer and/or an organic layer, and may have a single-layer or multi-layer structure. The second insulating layer 20 may include at least one of aluminum oxide, titanium oxide, silicon oxide, silicon nitride, silicon oxynitride, zirconium oxide, or hafnium oxide. For example, the second insulating layer 20 may be a single layer made of silicon oxide. The gate electrode GE may be disposed on the second insulating layer 20. The gate electrode GE may correspond to a gate of the connection transistor TR. Further, the gate electrode GE may be connected to the first node (N1 in FIG. 2A or N1 in FIG. 2B).

The gate electrode GE may be disposed on top of the semiconductor pattern SP. However, this is shown by way of example, and the gate electrode GE may be disposed below the semiconductor pattern SP. The disclosure is not limited to any one embodiment.

The gate electrode GE may include titanium (Ti), silver (Ag), molybdenum (Mo), aluminum (Al), aluminum nitride (AlN), tungsten (W), tungsten nitride (WN), copper (Cu), or alloys thereof, etc. However, this is an example, and an embodiment is not limited thereto.

The third insulating layer 30 may be disposed on the gate electrode GE. The third insulating layer 30 may be an inorganic layer and/or an organic layer, and may have a single-layer or multi-layer structure. The third insulating layer 30 may include at least one of aluminum oxide, titanium oxide, silicon oxide, silicon nitride, silicon oxynitride, zirconium oxide, or hafnium oxide.

A first capacitor electrode CPE1 and a second capacitor electrode CPE2 among conductive patterns W1, W2, CPE1, CPE2, and CPE3 may constitute the first capacitor C1. The first capacitor electrode CPE1 and the second capacitor electrode CPE2 may be spaced apart from each other while the first insulating layer 10 and the second insulating layer 20 are interposed therebetween.

The first capacitor electrode CPE1 and the bottom conductive layer BCL may have an integral structure with each other. Further, the second capacitor electrode CPE2 and the gate electrode GE may have an integral structure with each other.

The third capacitor electrode CPE3 may be disposed on the third insulating layer 30. The third capacitor electrode CPE3 may be spaced apart from the second capacitor electrode CPE2 while the third insulating layer 30 is therebetween, and may overlap the second capacitor electrode CPE2 in a plan view. The third capacitor electrode CPE3 and the second capacitor electrode CPE2 may constitute the second capacitor C2.

The fourth insulating layer 40 may be disposed on the third insulating layer 30 and/or the third capacitor electrode CPE3. The fourth insulating layer 40 may be an inorganic layer and/or an organic layer, and may have a single-layer or multi-layer structure. The fourth insulating layer 40 may include at least one of aluminum oxide, titanium oxide, silicon oxide, silicon nitride, silicon oxynitride, zirconium oxide, or hafnium oxide.

The source electrode pattern W1 and the drain electrode pattern W2 may be disposed on the fourth insulating layer 40. The source electrode pattern W1 may be connected to the bottom conductive layer BCL via a through-hole (not shown). Further, the source electrode pattern W1 may be connected to the source area SR of the connection transistor TR via a first through-hole CNT1. The drain electrode pattern W2 may be connected to the drain area DR of the connection transistor TR via a second through-hole CNT2.

The fifth insulating layer 50 may be disposed on the source electrode pattern W1 and the drain electrode pattern W2. The connection wiring CN may be disposed on the fifth insulating layer 50 and the sixth insulating layer 60. The connection wiring CN may electrically connect the pixel driver PDC and the light emitting device LD to each other. For example, the connection wiring CN may electrically connect the connection transistor TR and the light emitting device LD to each other. The connection wiring CN may be a connection node connecting the pixel driver PDC and the light emitting device LD to each other. For example, the connection wiring CN may correspond to the fourth node N4 as shown in FIG. 2A or the second node N2 as shown in FIG. 2B. However, this is an example. As long as the connection wiring CN may be connected to the light emitting device LD, the connection wiring CN may be defined as a connection node with each of various elements among elements constituting the pixel driver PDC according to a design of the pixel driver PDC. The disclosure is not limited to any one embodiment.

The sixth insulating layer 60 may be disposed on the connection wiring CN. The sixth insulating layer 60 may be disposed on the fifth insulating layer 50 so as to cover the connection wiring CN. In one example, the sixth insulating layer 60 may be omitted or include layers. The disclosure is not limited to any one embodiment.

Each of the fifth insulating layer 50 and the sixth insulating layer 60 may be an organic layer. For example, each of the fifth insulating layer 50 and the sixth insulating layer 60 may include a general-purpose polymer such as BCB (Benzocyclobutene), polyimide, HMDSO (Hexamethyldisiloxane), Polymethylmethacrylate (PMMA), or polystyrene (PS), a polymer derivative having a phenolic group, an acrylate-based polymer, an imide-based polymer, an arylether-based polymer, an amide-based polymer, a fluorine-based polymer, a p-xylene-based polymer, a vinyl alcohol-based polymer, or blends thereof.

An opening exposing at least a portion of the connection wiring CN may be defined in the sixth insulating layer 60. The connection wiring CN may be electrically connected to the light emitting device LD via a portion thereof exposed through the opening defined in the sixth insulating layer 60. For example, the connection wiring CN may electrically connect the connection transistor TR and the light emitting device LD to each other. The light emitting device layer LDL may be disposed on the sixth insulating layer 60. The light emitting device layer LDL may include a pixel defining film PDL, the light emitting device LD, and the separator SPR.

The pixel defining film PDL may be an organic layer. For example, the pixel defining film PDL may include a general-purpose polymer such as BCB (Benzocyclobutene), polyimide, HMDSO (Hexamethyldisiloxane), Polymethylmethacrylate (PMMA), or polystyrene (PS), a polymer derivative having a phenolic group, an acrylate-based polymer, an imide-based polymer, an arylether-based polymer, an amide-based polymer, a fluorine-based polymer, a p-xylene-based polymer, a vinyl alcohol-based polymer, or blends thereof.

The pixel defining film PDL may have a property of absorbing light. For example, the pixel defining film PDL may have a black color. The pixel defining film PDL may include a black coloring agent. The black coloring agent may include black dyes and black pigments. The black coloring agent may include carbon black, a metal such as chromium, or an oxide thereof. The pixel defining film PDL may act as a light blocking pattern having light blocking properties.

The light-emitting opening OP-PDL exposing at least a portion of the first electrode EL1 to be described below may be defined in the pixel defining film PDL. Light-emitting openings OP-PDL may be disposed in a corresponding manner to the light emitting devices LD, respectively. All components of the light emitting device LD may be disposed in the light-emitting opening OP-PDL so as to overlap each other. The light-emitting opening OP-PDL may be an area in which light emitted from the light emitting device LD is substantially emitted. Accordingly, a shape of the above-described emitting part EP (FIG. 3A and FIG. 4A) may substantially correspond to a shape of the light-emitting opening OP-PDL in a plan view. The light emitting device LD may include the first electrode EL1, an intermediate layer IML, and the second electrode EL2. Hereinafter, a description about the light emitting device LD may be equally applied to each of the first to third light emitting devices LD1, LD2, and LD3 as shown in FIG. 4A.

The first electrode EL1 may be a transmissive, transflective, or reflective electrode. In an embodiment, the first electrode EL1 may include a reflective layer made of silver, magnesium, aluminum, platinum, palladium, gold, nickel, neodymium, iridium, chromium, or a compound thereof, and a transmissive or transflective electrode layer formed on the reflective layer. The transmissive or transflective electrode layer may include at least one selected from a group consisting of indium tin oxide (ITO), indium zinc oxide (IZO), indium gallium zinc oxide (IGZO), zinc oxide (ZnO) or indium oxide (In₂O₃), and aluminum doped zinc oxide (AZO). For example, the first electrode EL1 may include a stacked structure of ITO/Ag/ITO.

In an embodiment, the first electrode EL1 may be an anode of the light emitting device LD. For example, the first electrode EL1 may be connected to the first power line VDL (FIG. 2A) and the first power voltage VDD (FIG. 2A) may be applied thereto. The first electrode EL1 may be connected to the first power line VDL in the display area DA or may be connected to the first power line VDL in the peripheral area NDA. In the latter case in which, in the peripheral area NDA, the first electrode EL1 is connected to the first power line VDL, the first power line VDL may be disposed in the peripheral area NDA, and the first electrode EL1 may have a shape extending to the peripheral area NDA.

In the schematic cross-sectional view of FIG. 5, it is illustrated that the first electrode EL1 overlaps the light-emitting opening OP-PDL and does not overlap the separator SPR. As described above, the first electrodes EL1 of the pixels PX11 to PXnm may have an integral structure with each other and may have a mesh or grid shape in which the openings OP-EL1 are defined in a partial area thereof. For example, as long as the same first power voltage VDD may be applied to the first electrodes EL1 of the light emitting devices LD1, LD2, and LD3 (FIG. 4A), the shape of the first electrode EL1 may be provided in various ways. The disclosure is not limited to any one embodiment.

The intermediate layer IML may be disposed between the first electrode EL1 and the second electrode EL2. The intermediate layer IML may include an emitting layer EML and a function layer FNL. However, this is an example, and the light emitting device LD may include the intermediate layer IML of each of various structures. The disclosure is not limited to any one embodiment. For example, the function layer FNL may be embodied as layers or as two or more layers spaced apart from each other while the emitting layer EML is interposed therebetween. By way of example, unlike what is shown, the function layer FNL may be omitted.

The function layer FNL may control transfer of electric charges between the first electrode EL1 and the second electrode EL2. The function layer FNL may include a hole injection/transport material and/or an electron injection/transport material. The function layer FNL may include at least one of an electron blocking layer, a hole transporting layer, a hole injection layer, a hole blocking layer, an electron transporting layer, an electron injection layer, and an electric charge generating layer.

The function layer FNL may be disposed between the first electrode EL1 and the emitting layer EML, or may be disposed between the emitting layer EML and the second electrode EL2. By way of example, the function layer FNL may be disposed between the first electrode EL1 and the emitting layer EML and between the second electrode EL2 and the emitting layer EML. In FIG. 5, the function layer FNL is shown as being disposed between the first electrode EL1 and the emitting layer EML and between the emitting layer EML and the second electrode EL2. However, an embodiment is not limited thereto. The position of the function layer FNL may include various examples in case that the function layer FNL can control movement of holes and/or electrons. The disclosure is not limited to any one embodiment.

The emitting layer EML may be disposed on the first electrode EL1. The emitting layer EML may be embedded in the function layer FNL. However, an embodiment is not limited thereto, and the function layer FNL may include a layer disposed between the emitting layer EML and the first electrode EL1, and/or a layer disposed between the emitting layer EML and the second electrode EL2, wherein each of the layers may be embodied as a stack of layers. The disclosure is not limited to any one embodiment. Further, in FIG. 5, the emitting layer EML and the function layer FNL are shown as having different shapes. However, the disclosure is not limited thereto, and the light-emitting layer EML and the function layer FNL may have the same shape in a plan view.

The emitting layers EML respectively included in the emitting parts EP adjacent to each other may include light-emitting materials emitting light beams of different colors. The emitting layer EML may provide one of blue, red, and green light. However, the disclosure is not limited thereto, and the emitting layers EML respectively disposed in all of the emitting parts EP may include a light-emitting material emitting light of the same color. The emitting layers EML may provide blue light or white light. The emitting layer EML may include an organic light-emitting material, an inorganic light-emitting material, an organic-inorganic light-emitting material, a quantum dot, a quantum rod, a micro LED, or a nano LED.

The second electrode EL2 may be disposed on the intermediate layer IML. As described above, the second electrode EL2 may be connected to the pixel driver PDC via the node (N4 in FIG. 2A or N2 in FIG. 2B). In an embodiment, the second electrode EL2 may be electrically connected to the connection transistor TR via the connection wiring CN.

An encapsulation layer ECL may be disposed on the light emitting device layer LDL. The encapsulation layer ECL may cover the light emitting device LD and may cover the separator SPR. The encapsulation layer ECL may include a first inorganic layer IL1, an organic layer OL, and a second inorganic layer IL2 sequentially stacked each other. However, the disclosure is not limited thereto, and the encapsulation layer ECL may further include inorganic layers and organic layers. Further, the encapsulation layer ECL may be a glass substrate.

The first and second inorganic layers IL1 and IL2 may protect the light emitting device layer LDL from moisture and oxygen outside the display panel DP. The organic layer OL may protect the light emitting device layer LDL from foreign materials such as particles remaining in a process of forming the first inorganic layer IL1. Each of the first and second inorganic layers IL1 and IL2 may include a silicon nitride layer, a silicon oxynitride layer, a silicon oxide layer, a titanium oxide layer, or an aluminum oxide layer. The organic layer OL may include an acrylate-based organic layer. However, a type of a material is not limited thereto.

The sensing layer ISL may sense an external input. The sensing layer ISL may be formed on the light emitting device layer LDL using a consecutive process. In this regard, the sensing layer ISL may be directly disposed on the encapsulation layer ECL and may contact the encapsulation layer ECL. As used herein, one element being 'directly disposed' on another element may mean that no third element is disposed between one element and another element, and one element and another element contact each other. However, this is an example, and the sensing layer ISL may be formed separately, and may be combined with the light emitting device layer LDL via an adhesive member. The disclosure is not limited to any one embodiment.

The sensing layer ISL may include conductive layers MTL1 and MTL2 and sensing insulating layers 71, 72, and 73. The sensing layer ISL may include the first to third sensing insulating layers 71, 72, and 73. However, this is shown by way of example, and the number of the sensing insulating layers 71, 72, and 73 constituting the sensing layer ISL is not limited to any one embodiment.

Each of the first to third sensing insulating layers 71, 72, and 73 may have a single-layer structure or a multi-layer structure in which layers may be stacked on each other along the third direction DR3. Each of the first to third sensing insulating layers 71, 72, and 73 may include an inorganic film. The inorganic film may include at least one of aluminum oxide, titanium oxide, silicon oxide, silicon nitride, silicon oxynitride, zirconium oxide, or hafnium oxide. Each of the first to third sensing insulating layers 71, 72, and 73 may include an organic film. The organic film may include at least one of acrylate-based resin, methacrylate-based resin, polyisoprene, vinyl-based resin, epoxy-based resin, urethane-based resin, cellulose-based resin, siloxane-based resin, polyimide-based resin, polyamide-based resin, and perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be connected to the first sensing conductive layer MTL1 via a contact hole CNT formed in the second sensing insulating layer 72. Each of the first and second sensing conductive layers MTL1 and MTL2 may have a single-layer structure or a multi-layer structure in which layers may be stacked on each other along the third direction DR3.

The sensing conductive layer having a single-layer structure may include a metal layer or a transparent conductive layer. The metal layer may include molybdenum, silver, titanium, copper, aluminum, or an alloy thereof. The transparent conductive layer may include a transparent conductive oxide such as indium tin oxide, indium zinc oxide, zinc oxide, or indium zinc tin oxide. By way of example, the transparent conductive layer may include a conductive polymer such as poly(3,4-ethylenedioxythiophene) (PEDOT), a metal nanowire, graphene, and the like within the scope of the disclosure.

The sensing conductive layer having a multi-layer structure may include metal layers. The metal layers may include, for example, a titanium layer/an aluminum layer/a titanium layer. The conductive layer having a multi-layer structure may include at least one metal layer and at least one transparent conductive layer.

The first sensing conductive layer MTL1 and the second sensing conductive layer MTL2 may constitute a sensor that detects an external input in the sensing layer ISL. The sensor may operate in a capacitance-based manner or may operate either a mutual-cap scheme or a self-cap scheme. However, this is an example, and the sensor may operate in a resistive film-based scheme, an ultrasonic wave-based scheme, or an infrared-ray based scheme in addition to the capacitance-based scheme. The disclosure is not limited to any one embodiment.

Each of the first sensing conductive layer MTL1 and the second sensing conductive layer MTL2 may include a transparent conductive oxide or may have a metal mesh shape made of an opaque conductive material. Each of the first sensing conductive layer MTL1 and the second sensing conductive layer MTL2 may be made of each of various materials and may have each of various shapes as long as visibility of the image displayed based on the light generated from the display panel DP is not deteriorated. The disclosure is not limited to any one embodiment. The connection wiring CN according to an embodiment may include the driver connection part CD and the emission connection part CE. The connection wiring CN will be described with referring to FIG. 5 and FIG. 6.

The driver connection part CD may be a portion of the connection wiring CN connected to the pixel driver PDC, and may be a portion thereof substantially connected to the connection transistor TR. In an embodiment, the driver connection part CD may extend through the fifth insulating layer 50 and be electrically connected to the drain area DR of the semiconductor pattern SP via the drain electrode pattern W2.

The emission connection part CE may be a portion of the connection wiring CN connected to the light emitting device LD. The emission connection part CE may be defined in an area not covered with the sixth insulating layer 60 and may be a portion directly connected to the second electrode EL2. In this regard, the tip part TP may be defined in the emission connection part CE.

Referring to FIG. 5 and FIG. 6, the connection wiring CN may include a structure in which three layers may be stacked on each other. By way of example, the connection wiring CN may include a first layer L1, a second layer L2, and a third layer L3 sequentially stacked on each other along the third direction DR3. The first layer L1 may have a relatively smaller thickness compared to that of the second layer L2. For example, the first layer L1 may include titanium (Ti).

The second layer L2 may include a material different from that of the first layer L1. The second layer L2 may include a material different from that of the third layer L3. The second layer L2 may have a relatively larger thickness compared to that of the first layer L1. Further, the second layer L2 may have a relatively larger thickness compared to that of the third layer L3. The second layer L2 may include a highly conductive material. For example, the second layer L2 may include aluminum (Al). The first layer L1 may include a material having a lower etch rate than that of the second layer L2. For example, the first layer L1 and the second layer L2 may be respectively composed of materials having high etch selectivity relative to each other. In an embodiment, the first layer L1 may include titanium (Ti), and the second layer L2 may include aluminum (Al). A side face L1_W of the first layer L1 may be defined outwardly of a side face L2_W of the second layer L2. For example, the emission connection part CE of the connection wiring CN may have a shape in which the side face L1_W of the first layer L1 is positioned outwardly beyond the side face L2_W of the second layer L2. For example, the emission connection part CE of the connection wiring CN may have a shape in which the side face L2_W of the second layer L2 is positioned inwardly of the side face L1_W of the first layer L1.

The third layer L3 may include a material having a lower etching rate than that of the second layer L2. The third layer L3 may include a material having a lower etch selectivity with respect to that of the second layer L2. For example, the third layer L3 may include titanium (Ti). For example, the third layer L3 and the second layer L2 may be respectively composed of materials having a high etch selectivity relative to each other. In an embodiment, the third layer L3 may include titanium (Ti), and the second layer L2 may include aluminum (Al). A side face L3_W of the third layer L3 may be defined outwardly of the side face L2_W of the second layer L2. For example, the emission connection part CE of the connection wiring CN may have a shape in which the side face L3_W of the third layer L3 is positioned outwardly beyond the side face L2_W of the second layer L2. For example, the emission connection part CE of the connection wiring CN may have an undercut shape or an overhang structure. A portion of the third layer L3 positioned outwardly beyond the side face L2_W of the second layer L2 may constitute the tip part TP of the emission connection part CE.

The sixth insulating layer 60 and the pixel defining film PDL may not cover at least a portion of the tip part TP and at least a portion of the side face L2_W of the second layer L2. By way of example, a first auxiliary opening OP1 exposing one side or a side of the connection wiring CN may be defined in the sixth insulating layer 60, and a second auxiliary opening OP2 overlapping the first auxiliary opening OP1 may be defined in the pixel defining film PDL. An area size of the second auxiliary opening OP2 may be at least the same as that of the first auxiliary opening OP1 or may be larger than that of the first auxiliary opening OP1. However, an embodiment is not limited thereto. As long as at least a portion of the tip part TP and at least a portion of the side face L2_W of the second layer L2 are exposed, the area size of the second auxiliary opening OP2 may be smaller than or equal to that of the first auxiliary opening OP1.

The intermediate layer IML may be disposed on the pixel defining film PDL. The intermediate layer IML may also be disposed on a partial area of the sixth insulating layer 60 exposed through the second auxiliary opening OP2 of the pixel defining film PDL. Further, the intermediate layer IML may also be disposed on a partial area of the connection wiring CN exposed through the first auxiliary opening OP1 of the sixth insulating layer 60. As shown in FIG. 6, the intermediate layer IML may include one end IN1 disposed along a top face of the fifth insulating layer 50 and the other end IN2 disposed along a top face of the tip part TP of the connection wiring CN. For example, in the cross-sectional view, the intermediate layer IML may be partially discontinuous at the tip part TP in an area where the emission connection part CE is defined. However, in the plan view, the intermediate layer IML may have an integral shape extending in a continuous manner in an area (FIG. 4A) defined by a closed line of the separator SPR.

The second electrode EL2 may be disposed on the intermediate layer IML. The second electrode EL2 may also be disposed on a partial area of the sixth insulating layer 60 exposed through the second auxiliary opening OP2 of the pixel defining film PDL. The second electrode EL2 may also be disposed on a top face of the sixth insulating layer 60 and a partial area of the connection wiring CN exposed through the first auxiliary opening OP1. As shown in FIG. 6, the second electrode EL2 may include one end EN1 disposed along a top face of the fifth insulating layer 50 and the other end EN2 disposed on the top face of the tip part TP of the connection wiring CN. For example, in the cross-sectional view, the second electrode EL2 may be partially discontinuous at the tip part TP in an area where the emission connection part CE is defined. However, in the plan view, the second electrode EL2 may have an integral shape extending in a continuous manner in an area (FIG. 4A) defined by a closed line of the separator SPR.

In one example, one end EN1 of the second electrode EL2 may be disposed along a side face of the second layer L2 so as to contact the side face L2_W of the second layer L2. By way of example, due to a difference between deposition angles of the second electrode EL2 and the intermediate layer IML, the tip part TP of the second electrode EL2 may contact the side face L2_W of the second layer L2 not covered with the intermediate layer IML. For example, the second electrode EL2 may be connected to the connection wiring CN without a separate patterning process on the intermediate layer IML, and thus the light emitting device LD may be electrically connected to the pixel driver PDC via the connection wiring CN.

Further, in an embodiment, it is illustrated that the other end IN2 of the intermediate layer IML and the other end EN2 of the second electrode EL2 cover the side face L3_W of the third layer L3. This is shown by way of example, and at least a portion of the side face L3_W of the third layer L3 may not be covered with the other end IN2 of the intermediate layer IML and/or the other end EN2 of the second electrode EL2.

Referring back to FIG. 5, in an embodiment, the display panel DP may include the separator SPR. The separator SPR may be disposed on the pixel defining film PDL. In an embodiment, the second electrode EL2 and the intermediate layer IML may be commonly deposited across the pixels through an open mask. In this regard, the second electrode EL2 and the intermediate layer IML may be isolated by the separator SPR. As described above, the separator SPR may have a closed line shape in each of the emitting parts EP1, EP2, and EP3 (FIG. 4B). Accordingly, the second electrode EL2 and the intermediate layer IML of one of the emitting parts EP1, EP2, and EP3 (FIG. 4B) may be isolated from the second electrode EL2 and the intermediate layer IML of each of the others of the emitting parts EP1, EP2, and EP3 via the separator SPR. For example, the second electrode EL2 and the intermediate layer IML of one of adjacent pixels may be electrically isolated from the second electrode EL2 and the intermediate layer IML of the other of the adjacent pixels.

In an embodiment, the separator SPR may include an insulating material, for example, an organic insulating material. The separator SPR may include an inorganic insulating material, or may be composed of a stack of multiple layers respectively made of an organic insulating material and an inorganic insulating material. Depending on an embodiment, the separator SPR may include a conductive material. For example, as long as the second electrode EL2 of one of adjacent pixels is electrically isolated from the second electrode EL2 of the other of the adjacent pixels via the separator SPR, a material thereof is not particularly limited.

A dummy layer UP may be disposed on the separator SPR. The dummy layer UP may include a first dummy layer UP1 disposed on the separator SPR and a second dummy layer UP2 disposed on the first dummy layer UP1. The first dummy layer UP1 and the intermediate layer IML may be formed in the same process and may include a same material or a similar material. The second dummy layer UP2 and the second electrode EL2 may be formed in the same process and may include a same material or a similar material. For example, the first dummy layer UP1 and the second dummy layer UP2 may be formed in a manufacturing step of the intermediate layer IML and the second electrode EL2. Unlike what is shown, the dummy layer UP may be omitted.

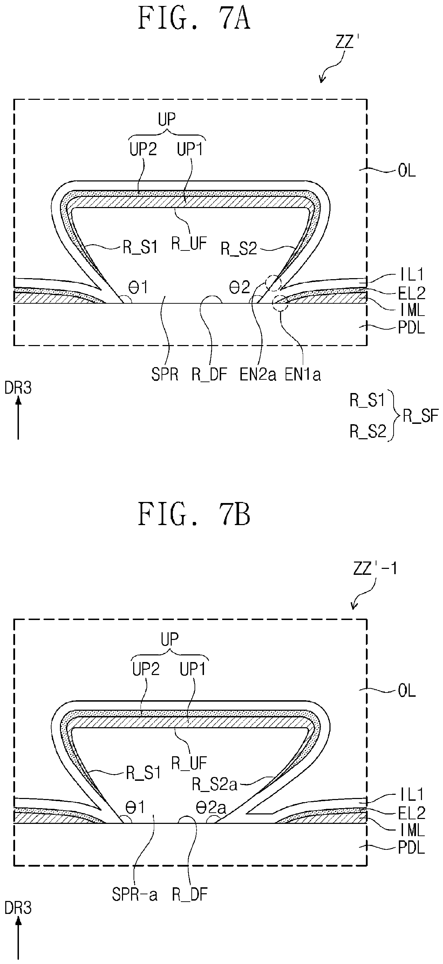

Further, in case that the intermediate layer IML and the second electrode EL2 are formed, a portion extending from the first dummy layer UP1 and a portion extending from the second dummy layer UP2 may be formed on a side face R_SF (FIG. 7A) of the separator SPR. Each of the portion extending from the first dummy layer UP1 and the portion extending from the second dummy layer UP2 formed on the side face R_SF (FIG. 7A) of the separator SPR may be very thin. However, an embodiment is not limited thereto, and the portion extending from the first dummy layer UP1 and the portion extending from the second dummy layer UP2 may not be formed on the side face R_SF (FIG. 7A) of the separator SPR.

FIG. 7A is an enlarged schematic cross-sectional view of an area ZZ' of FIG. 5. Referring to FIG. 7A, in an embodiment, the second electrode EL2 may include a first end EN1a, and the second dummy layer UP2 may include a second end EN2a. The first end EN1a may be spaced apart from the separator SPR and may be positioned on the pixel defining film PDL. The second end EN2a may be spaced from the first end EN1a and may be disposed on the side face R_SF of the separator SPR. However, in FIG. 7A, the first end EN1a is shown as being spaced apart from the side face R_SF of the separator SPR by a predefined spacing. An embodiment is not limited thereto. As long as the first end EN1a is electrically insulated from the second end EN2a, the first end EN1a may contact the side face R_SF of the separator SPR. Further, the first end EN1a and the second end EN2a may be connected to each other while not being distinguished from each other. A thickness of a portion formed along the side face R_SF of the separator SPR may be very small and thus an electrical resistance thereof may be large. In case that the second electrodes EL2 of adjacent pixels are electrically insulated from each other, it may be interpreted that the second electrodes EL2 of adjacent pixels may be isolated from each other via the separator SPR.

According to an embodiment, even in case that no separate patterning process is performed on the second electrode EL2 or the intermediate layer IML, the second electrode EL2 or the intermediate layer IML may be prevented from being formed on the side face R_SF of the separator SPR or may be formed to be very thin, such that the second electrodes EL2 or the intermediate layers IML of adjacent pixels may be isolated from each other. Referring to FIG. 7A, in the cross-sectional view, the separator SPR may include one face R_DF, the other face R_UF facing one face R_DF, and the side face R_SF disposed between one face R_DF and the other face R_UF. The side face R_SF may be inclined with respect to one face R_DF. In the thickness direction DR3, one face R_DF may be a bottom face adjacent to the pixel defining film PDL, and the other face R_UF may be a top face. In the cross-sectional view, the separator SPR may have a reverse taper shape. In the separator SPR, as an angle of an inclination of the side face R_SF with respect to the one face R_DF increases, the isolation of the second electrode EL2 and/or the intermediate layer IML may be more reliable. In the separator SPR, as the angle of the inclination of the side face R_SF with respect to the one face R_DF increases, an amount of flowing current and/or the amount of migrating electric charges decreases, thereby improving the isolation ability.

Referring to FIG. 7A, the side face R_SF of the separator SPR may include a first side face R_S1 and a second side face R_S2 spaced apart from each other in one direction or in a direction. The first side face R_S1 may be inclined at a first angle θ1 with respect to one face R_DF. The second side face R_S2 may be inclined at a second angle Θ2 with respect to one face R_DF. In FIG. 7A, the first angle θ1 and the second angle Θ2 may be substantially the same as each other. As used herein, A being substantially the same as B includes not only a case where numerical values of A and B are exactly equal to each other, but also a case where a difference therebetween may be within a process error range that may generally occur. Each of the first angle θ1 and the second angle Θ2 may be in a range of 90° exclusive to 180° exclusive. For example, each of the first angle θ1 and the second angle Θ2 may be greater than or equal to 110°. As each of the first angle θ1 and the second angle Θ2 increases, the isolation ability of the second electrode EL2 and/or the intermediate layer IML may be improved.

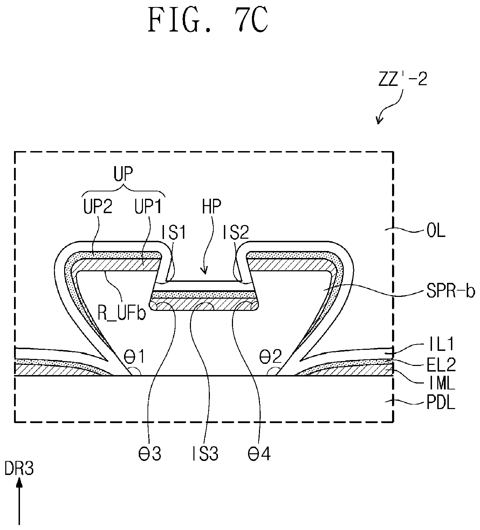

The area ZZ'-1 of FIG. 7B and the area ZZ'-2 of FIG. 7C are respectively schematic plan views showing further embodiments of separators SPR-a and SPR-b. The separator SPR-a as shown in FIG. 7B differs from the separator SPR as shown in FIG. 7A in that a second angle Θ2a of the second side face R_S2a is different from the first angle θ1. The second angle Θ2a of the second side face R_S2a may be different from the first angle θ1 of the first side face R_S1. The second angle Θ2a of the second side face R_S2a may be greater than the first angle θ1 of the first side face R_S1. For example, a difference between the second angle Θ2a and the first angle θ1 may be 10° or larger.

The second side face R_S2a may be more greatly inclined with respect to one face R_DF than the first side face R_S1 may be. For example, the separator SPR-a may be formed by performing patterning using a mask. The mask may include a mask having a slit or a halftone mask. After the mask has been provided, the separator SPR-a may be formed in an exposure process. In case that the mask including a slit or the halftone mask is provided, the separator SPR-a may be formed without change in a light amount in the exposure process. Accordingly, the first angle θ1 of the first side face R_S1 and the second angle Θ2a of the second side face R_S2a may be different from each other. The separator SPR-a in which the first angle θ1 of the first side face R_S1 and the second angle Θ2a of the second side face R_S2a are different from each other may have improved isolation ability of the second electrode EL2 and/or the intermediate layer IML.

The separator SPR-b as shown in FIG. 7C differs from the separator SPR as shown in FIG. 7A in that a groove HP is defined in the other face R_UFb. In an embodiment, the groove HP may be defined by a first inner side face IS 1, a second inner side face IS2 spaced from the first inner side face IS1 in one direction or in a direction, and an inner bottom face IS3 disposed between the first inner side face IS1 and the second inner side face IS2. Each of the first inner side face IS 1 and the second inner side face IS2 may be inclined with respect to the inner bottom face IS3. The first inner side face IS1 may be inclined at a third angle θ3 with respect to the inner bottom face IS3. The second inner side face IS2 may be inclined at a fourth angle θ4 with respect to the inner bottom face IS3. The third angle θ3 and the fourth angle θ4 may be substantially the same as each other. For example, each of the third angle θ3 and the fourth angle θ4 may be greater than or equal to 100°. In the cross-sectional view, the groove HP may have a shape obtained by turning the separator SPR as shown in FIG. 7A upside down. The separator SPR-b in which the groove HP is defined may have improved isolation ability of the second electrode EL2 and/or intermediate layer IML.

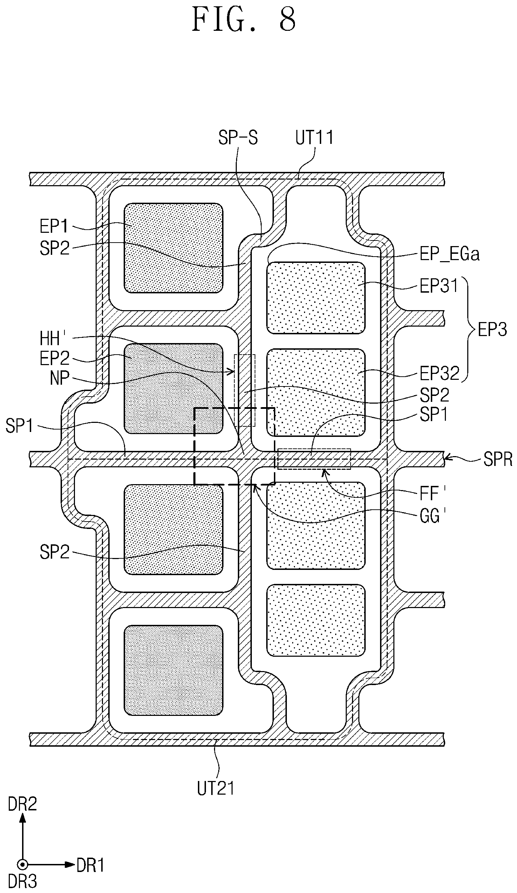

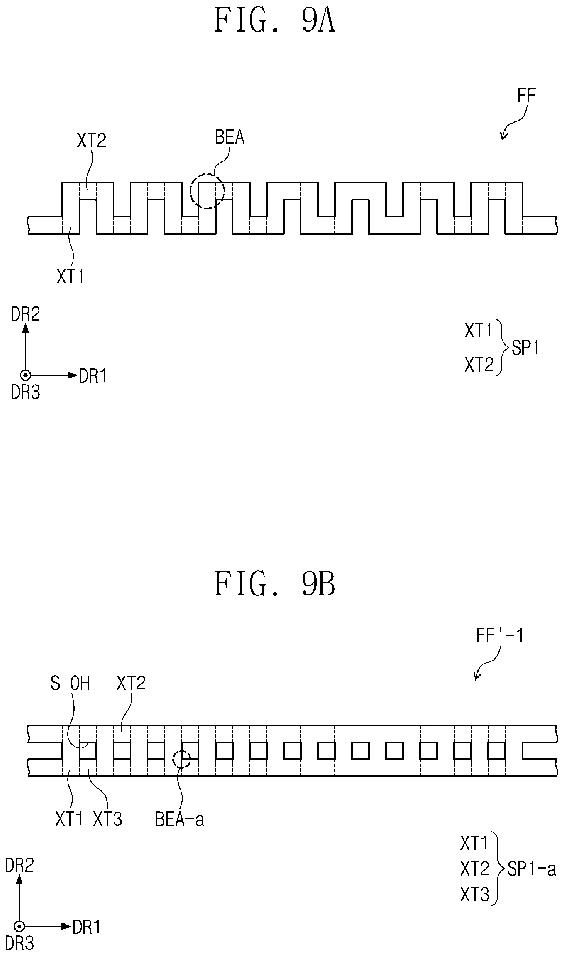

FIG. 8 is a schematic plan view showing the first row first column light emitting unit UT11 and the second row first column light emitting unit UT21 of FIG. 4A. For convenience of illustration, the connection wirings CN1, CN2, CN3, and CN-c may be omitted from FIG. 8. FIG. 9A is an enlarged schematic plan view of an area FF' in FIG. 8. FIG. 9A may be a detailed illustration of a first isolation portion SP1 of the separator SPR. An area FF'-1 in FIG. 9B is a schematic plan view representing an embodiment of the area FF', and may represent an embodiment of a first isolation portion SP1-a.

Referring to FIG. 9A, the separator SPR may include the first isolation portion SP1. The first isolation portion SP1 may extend in the first direction DR1 and may be disposed between the first row first column light emitting unit UT11 (hereinafter, a first light emitting unit) and the second row first column light emitting unit UT21 (hereinafter, a second light emitting unit) spaced apart from each other in the second direction DR2. In an embodiment, the first isolation portion SP1 may include first portions XT1 spaced apart from each other and second portions XT2, wherein each of the second portions XT2 may be disposed between the adjacent ones of the first portions XT1. The second portion XT2 may be bent from the first portion XT1. The first portions XT1 and the second portions XT2 may be alternately arranged or disposed with each other. The first portions XT1 and the second portions XT2 may have an integral structure with each other.

Referring to FIG. 9A, each of the first portions XT1 may extend in the second direction DR2, and each of the second portions XT2 may extend in the first direction DR1 intersecting the second direction DR2. For example, in the first isolation portion SP1, two first portions XT1 and one second portion XT2 disposed therebetween may constitute a U shape (or an inverted U shape). In the first isolation portion SP1, each of the first portions XT1 and each of the second portions XT2 may extend in directions that intersect each other. Thus, the first isolation portion SP1 may include a bent portion BEA composed of a portion of the first portion XT1 and a portion of the second portion XT2. As the first isolation portion SP1 may include the bent portion BEA, each of the above-described first and second angles θ1 and θ2 of the separator SPR including the first isolation portion SP1 may increase. As each of the first and second angles θ1 and Θ2 increases, the separator SPR may have improved isolation ability. On the contrary, a separator free of the bent portion and including an isolation portion extending in a straight line requires a larger area. The separator should be disposed within a predefined area in a plan view. In case that the separator requires a larger area, an area occupied with other components (for example, the emitting part) may be reduced. In case that the area occupied with the other components is reduced, display quality and the like are degraded. The separator SPR including the bent portion BEA of an embodiment may be disposed within a predefined area while the area occupied with the other components is not reduced. Thus, the separator SPR may have improved isolation ability.

The first isolation portion SP1-a as shown in FIG. 9B differs from the first isolation portion SP1 as shown in FIG. 9A in that the former may further include third portions XT3. In the description of FIG. 9B, the contents duplicate with the contents as described with reference to FIG. 9A are not described again, and the description focuses on the differences therebetween.

Referring to FIG. 9B, each of the third portions XT3 may be bent from each of the first portions XT1. The third portion XT3 may extend in a direction parallel to an extension direction of the second portion XT2. Each of the third portions XT3 may extend in the first direction DR1 and may be spaced apart from each of the second portions XT2 in the second direction DR2. In the first isolation portion SP1-a, the first portion XT1 and the third portion XT3 may respectively extend in directions that intersect each other, so that the first isolation portion SP1-a may include a bent portion BEA-a composed of a portion of the first portion XT1 and a portion of the third portion XT3. Accordingly, each of the above-described first and second angles θ1 and Θ2 of the separator SPR including the first isolation portion SP1-a may increase. As each of the first and second angles θ1 and Θ2 increases, the isolation ability of the separator SPR may be improved.

A first opening S_OH may be defined in the first isolation portion SP1-a. In the first isolation portion SP1-a, two first portions XT1 adjacent to each other, one second portion XT2 disposed between the two adjacent first portions XT1, and one third portion XT3 disposed between the two adjacent first portions XT1 may define the first opening S_OH. The first portion XT1 and the second and third portions XT2 and XT3 respectively extending in directions intersecting each other may constitute a quadrangular shape. Accordingly, the first opening S_OH may be defined as a square shape in the plan view.

Referring to FIG. 8 again, the separator SPR may further include an intersection NP and a second isolation portion SP2. In the separator SPR, the first isolation portion SP1, the intersection NP, and the second isolation portion SP2 may have an integral structure with each other. The second isolation portion SP2 may extend in a direction intersecting the extension direction of the first isolation portion SP1.

At least one of the first isolation portion SP1 or the second isolation portion SP2 may include portions. The intersection NP may be disposed between two isolation portions (two first isolation portions or two second isolation portions) extending in one direction or in a direction, while the other isolation portion (a second or first isolation portion) extending in the other direction intersecting the one direction or in a direction may extend from the intersection NP. For example, in the separator SPR, at least two first isolation portions SP1 may be provided, and the intersection NP may be disposed between the two first isolation portions SP1. The two first isolation portions SP1 may be spaced apart from each other in the first direction DR1. The second isolation portion SP2 may extend from the intersection NP in the second direction DR2. By way of example, in the separator SPR, at least two second isolation portions SP2 may be provided, and the intersection NP may be disposed between the two second isolation portions SP2. The two second isolation portions SP2 may be spaced apart from each other in the second direction DR2. A width in the second direction DR2 of the intersection NP may be greater than that of the first isolation portion SP1. A width in the first direction DR1 of the intersection NP may be larger than that of the second isolation portion SP2.

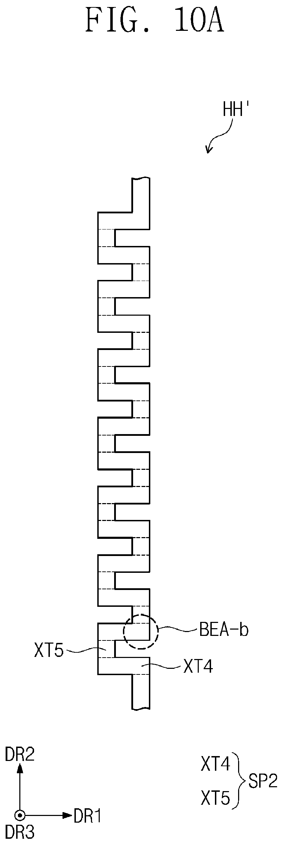

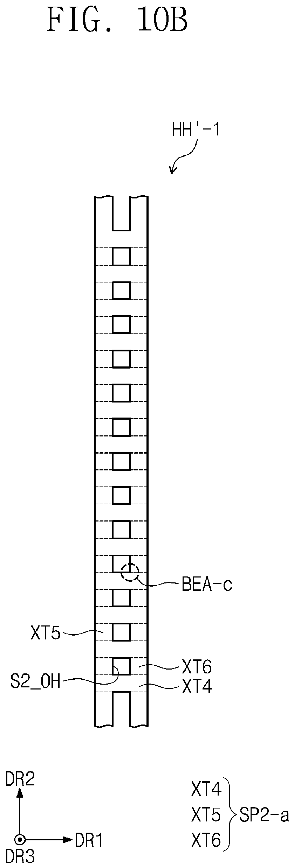

FIG. 10A is an enlarged schematic plan view of an area HH' in FIG. 8. FIG. 10A may be a schematic plan view showing the second isolation portion SP2 in detail. An area HH'-1 in FIG. 10B may be a schematic plan view representing an embodiment of the area HH', and may represent an embodiment of a second isolation portion SP2-a. The second isolation portion SP2 as shown in FIG. 10A may have the same shape as that of the first isolation portion SP1 as shown in FIG. 9A rotated by about 90° in a counterclockwise direction. The second isolation portion SP2-a as shown in FIG. 10B may have the same shape as that of the first isolation portion SP1-a as shown in FIG. 9B rotated by about 90° in a counterclockwise direction.

Referring to FIG. 10A, the second isolation portion SP2 may include fourth portions XT4 spaced apart from each other and fifth portions XT5, wherein each of the fifth portions XT5 may be disposed between adjacent ones of the fourth portions XT4. Each of the fifth portions XT5 may be bent from each of the fourth portions XT4. The fourth portions XT4 and the fifth portions XT5 may be alternately arranged or disposed with each other. The fourth portions XT4 and fifth portions XT5 may have an integral structure with each other.

Each of the fourth portions XT4 may extend in the first direction DR1, and each of the fifth portions XT5 may extend in the second direction DR2 intersecting the first direction DR1. For example, in the second isolation portion SP2, two fourth portions XT4 and one fifth portion XT5 may constitute a U shape (or an inverted U). In the second isolation portion SP2, the fourth portion XT4 and the fifth portion XT5 may respectively extend in directions that intersect each other. Thus, the second isolation portion SP2 may include a bent portion BEA-b composed of a portion of the fourth portion XT4 and a portion of the fifth portion XT5. As the second isolation portion SP2 may include the bent portion BEA-b, each of the first and second angles θ1 and Θ2 of the separator SPR including the second isolation portion SP2 may increase. As each of the first and second angles θ1 and Θ2 increases, the isolation ability of the separator SPR may be improved.

The second isolation portion SP2-a as shown in FIG. 10B differs from the second isolation portion SP2 as shown in FIG. 10A in that the former further may include sixth portions XT6. In the description of FIG. 10B, the contents duplicate with the description with reference to FIG. 10A are not described again, and the description focuses on the differences therebetween.

Referring to FIG. 10B, each of the sixth portions XT6 may be bent from each of the fourth portions XT4. The sixth portion XT6 may extend in a direction parallel to a direction in which the fifth portion XT5 extends. The sixth portions XT6 may extend in the second direction DR2 and may be spaced apart from the fifth portions XT5 in the first direction DR1. In the second isolation portion SP2-a, each of the fourth portions XT4 and each of the sixth portions XT6 may respectively extend in directions that intersect each other, so that the second isolation portion SP2-a may include a bent portion BEA-c composed of a portion of each of the fourth portions XT4 and a portion of each of the sixth portions XT6. Accordingly, each of the above-described first and second angles θ1 and Θ2 of the separator SPR including the second isolation portion SP2-a may increase. As each of the first and second angles θ1 and Θ2 increases, the isolation ability of the separator SPR may be improved.

A second opening S2_OH may be defined in the second isolation portion SP2-a. In the second isolation portion SP2-a, two fourth portions XT4 adjacent to each other, one fifth portion XT5 disposed between the two adjacent fourth portions XT4, and one sixth portion XT6 disposed between the two adjacent fourth portions XT4 may define the second opening S2_OH. The fourth portion XT4 and the fifth and sixth portions XT5 and XT6 respectively extending in directions intersecting each other may constitute a quadrangular shape. Accordingly, in a plan view, the second opening S2_OH may be defined as a square shape.

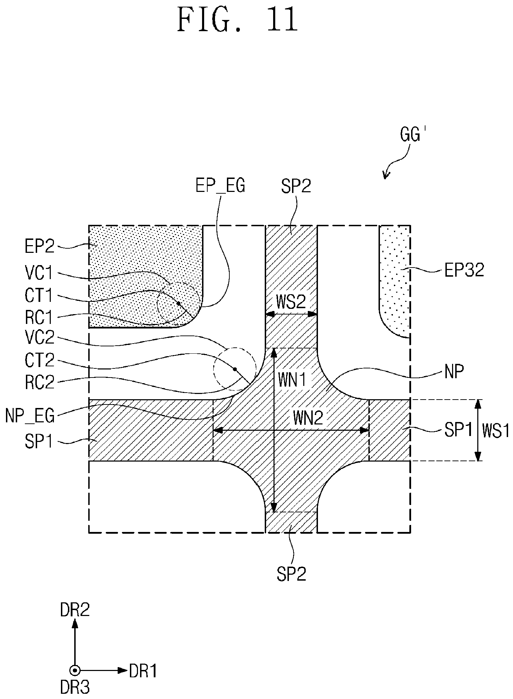

FIG. 11 is an enlarged schematic plan view of an area GG' in FIG. 8. FIG. 11 may be an enlarged schematic plan view showing the intersection NP in FIG. 8. The intersection NP may include a portion having substantially the same curvature as that of at least one emitting part (for example, the second emitting part EP2). For example, an edge NP_EG of the intersection NP may be formed to have the same curvature as that of an edge EP_EG of the second emitting part EP2. Further, the edge NP_EG of the intersection NP may be formed to have the same curvature as that of an edge of one sub-emitting part EP32 of the third emitting part EP3 (FIG. 8). However, this is an example, and an emitting part having the same curvature as that of the intersection NP is not required. The description about the second emitting part EP2 as set forth above with reference to FIG. 11 may be equally applied to each of the other emitting parts EP1 and EP3.

The edge EP _EG of the second emitting part EP2 may correspond to an edge of the pixel defining film PDL in which the light-emitting opening OP-PDL (FIG. 5) is defined. In a plan view, the second emitting part EP2 may be defined as a rectangular shape including the edge EP_EG having a curvature.

In FIG. 11, a virtual circle VC1 (hereinafter, a first circle) tangent to the edge EP_EG of the second emitting part EP2 and a virtual circle VC2 (hereinafter, a second circle) tangent to the edge NP_EG of the intersection NP are shown. A length of a straight line from a center CT1 of the first circle VC1 to the edge EP_EG of the second emitting part EP2 may be a radius RC1 of the first circle VC1. A length of a straight line from a center CT2 of the second circle VC2 to the edge NP_EG of the intersection NP may be a radius RC2 of the second circle VC2. In an embodiment, as the edge NP_EG of the intersection NP and the edge EP_EG of the second emitting part EP2 have substantially the same curvature, the radius RC1 of the first circle VC1 and the radius RC2 of the second circle VC2 may be substantially the same as each other.

The intersection NP including the edge NP_EG having a curvature may have a larger width than that of each of the first and second isolation portions SP1 and SP2. A first width WN1 in the second direction DR2 of the intersection NP may be greater than a width WS1 in the second direction DR2 of the first isolation portion SP1. A second width WN2 in the first direction DR1 of the intersection NP may be greater than a width WS2 in the first direction DR1 of the second isolation portion SP2. Each of the width WS1 of the first isolation portion SP1 and the width WS2 of the second isolation portion SP2 may be uniform. A contact area of the intersection NP having a larger width than that of each of the first and second isolation portions SP1 and SP2 may be increased, such that loss thereof may be prevented. Accordingly, the isolation ability of the separator SPR including the intersection NP may be improved.

The intersection NP may have a non-uniform width. The intersection NP may have a width that decreases as the intersection NP extends toward the first isolation portion SP1. The intersection NP may have a width that decreases as the intersection NP extends toward the second isolation portion SP2. Further, a maximum width in the first direction DR1 of the intersection NP may be greater than a maximum width in the second direction DR2 of the intersection NP. However, an embodiment is not limited thereto, and the maximum width in the first direction DR1 of the intersection NP may be equal to or smaller than the maximum width in the second direction DR2 of the intersection NP.

Referring back to FIG. 8, the separator SPR may further include a sub-isolation portion SP-S extending from the second isolation portion SP2 so as to have a curvature. The sub-isolation portion SP-S may extend so as to have a curvature while a uniform width thereof is maintained. The sub-isolation portion SP-S may have substantially the same curvature as that of an edge EP_EGa of the third emitting part EP3. In an embodiment, the separator SPR including the sub-isolation portion SP-S formed to have the curvature may have improved isolation ability.

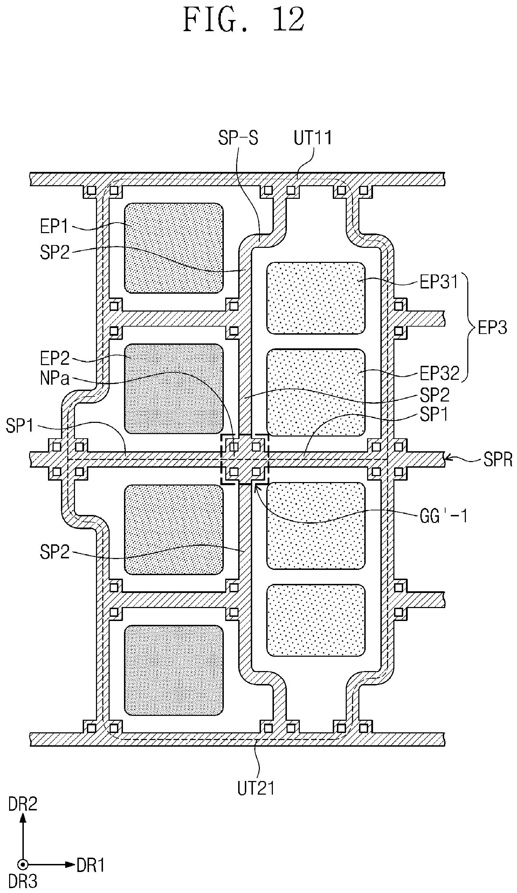

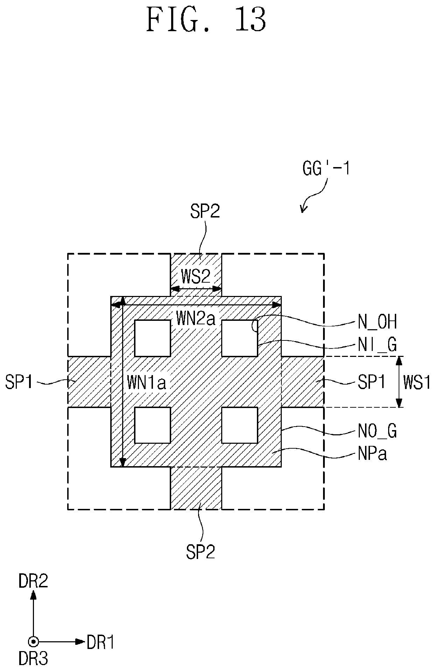

FIG. 12 is a schematic plan view showing an embodiment. The embodiment of FIG. 12 may be different from the schematic plan view of FIG. 8 in terms of a shape of an intersection NPa. FIG. 13 is an enlarged view of an area GG'-1 in FIG. 12. The shape of the intersection NPa may be different from that of the intersection NP in FIG. 11. FIG. 13 may be an enlarged schematic plan view showing the intersection NPa. In following descriptions of FIG. 12 and FIG. 13, the contents duplicate with the descriptions as set forth above with reference to FIG. 8 to FIG. 11 are not described again, but the description focuses on differences therebetween.

Referring to FIG. 12, the intersection NPa may have a rectangular shape without a curvature. The intersection NPa may be disposed between at least two first isolation portions SP1 and may have a larger width than that of the first isolation portion SP1.

Referring to FIG. 13, the intersection NPa may include four outer edges NO_G defining a rectangular shape. Two outer edges NO_G among the four outer edges NO_G may extend in a parallel manner to the first direction DR1, and the remaining two outer edges NO_G thereof may extend in a parallel manner to the second direction DR2. A first width WN1a of the intersection NPa may be defined as a straight line distance between the two parallel outer edges NO_G extending in the first direction DR1. A second width WN2a of the intersection NPa may be defined as a straight line distance between the two parallel outer edges NO_G extending in the second direction DR2. The quadrangular intersection NPa may include a bent portion, so that the isolation ability of the separator SPR may be improved.

A quadrangular third opening N_OH may be defined in the intersection NPa. The intersection NPa may include four inner edges NI_G defining the third opening N_OH. Two inner edges NI_G among the four inner edges NI_G may extend in a parallel manner to the second direction DR2, and the remaining two inner edges NI_G thereof may extend in a parallel manner to the first direction DR1.

An inner edge NI_G further away from the outer edge NO_G among the two inner edges NI_G extending in the second direction DR2 may be in a line with an edge of the second isolation portion SP2. An inner edge NI_G further away from the outer edge NO_G among the two inner edges NI_G extending in the first direction DR1 may be in a line with an edge of the first isolation portion SP1. However, an embodiment is not limited thereto, and the inner edge NI_G may be not in a line with the edge of each of the first and second isolation portions SP1 and SP2.

Third openings N_OH may be defined in the intersection NPa. FIG. 13 shows four third openings N_OH. A spacing in the first direction DR1 between adjacent ones of the third openings N_OH may be substantially the same as the width WS2 of the second isolation portion SP2. A spacing in the second direction DR2 between adjacent ones of the third openings N_OH may be substantially the same as the width WS1 of the first isolation portion SP1. However, an embodiment is not limited thereto, and the spacing between adjacent ones of the third openings N_OH may be different from each of the widths WS1 and WS2 of the first and second isolation portions SP1 and SP2.

The display panel of an embodiment may include a first light emitting unit and a second light emitting unit spaced apart from each other. Each of the first light emitting unit and the second light emitting unit may include a separator and at least one emitting part. The separator may include a first isolation portion, and the first isolation portion may include first portions spaced apart from each other and second portions, wherein each of the second portions may be disposed between adjacent ones of the first portions. Each of the second portions may be bent (e.g. extending at an angle) from each of the first portions. Further, the separator may include an intersection disposed between at least two first isolation portions. In one direction or in a direction, the intersection may have a larger width than that of the first isolation portion. Accordingly, the display panel including the separator may have improved isolation ability of the cathodes of the first and second light emitting units from each other.

A display panel of an embodiment may have a bent portion or a separator having an increased contact area and thus may have improved isolation ability of electrodes from each other.

The above description is an example of technical features of the disclosure, and those skilled in the art to which the disclosure pertains will be able to make various modifications and variations. Thus, the embodiments of the disclosure described above may be implemented separately or in combination with each other.
The protection scope of the disclosure should be interpreted by the following claims, and it should be interpreted that all technical features within the equivalent scope are included in the scope of the disclosure.
The present invention can also be defined by reference to the following clauses:
Clause 1. A display panel comprising:
   a first light-emitting unit and a second light-emitting unit spaced apart from each other, wherein
   each of the first light-emitting unit and the second light-emitting unit includes an separator and at least one emitting part,
   the separator includes a first isolation portion,
   the first isolation portion includes:
      first portions spaced apart from each other; and
      second portions,
   each of the second portions is disposed between adjacent ones of the first portions, and
   each of the second portions is bent from each of the first portions.
Clause 2. The display panel of clause 1, wherein
   each of the second portions extends in a first direction, and
   each of the first portions extends in a second direction intersecting the first direction.
Clause 3. The display panel of clause 1 or clause 2, wherein
   the first isolation portion further includes third portions,
   each of the third portions is disposed between adjacent ones of the first portions,
   each of the third portions is bent from each of the first portions, and
   each of the third portions is spaced apart from each of the second portions.
Clause 4. The display panel of clause 3, wherein two first portions adjacent to each other among the first portions, a second portion disposed between the two adjacent first portions among the second portions, and a third portion disposed between the two adjacent first portions among the third portions define a first opening.
Clause 5. The display panel of clause 3 or clause 4, wherein each of the third portions extends in parallel to a direction in which each of the second portions extends.
Clause 6. The display panel of any preceding clause, wherein
   the first isolation portion includes at least two first isolation portions,
   the separator further includes an intersection disposed between the two first isolation portions, and
   a first width in a first direction of the intersection is greater than a width in the first direction of each of the two first isolation portions.
Clause 7. The display panel of clause 6, wherein an edge of the emitting part and an edge of the intersection have a same curvature in a plan view.
Clause 8. The display panel of clause 6 or clause 7, wherein
   the separator further includes a second isolation portion extending from the intersection in a direction intersecting a direction in which the first isolation portion extends,
   a second width in a second direction of the intersection is greater than a width in the second direction of the second isolation portion, and the first direction intersects the second direction.
Clause 9. The display panel of clause 8, wherein
   the second isolation portion includes:
      fourth portions spaced apart from each other; and
      fifth portions,
   each of the fifth portions is disposed between adjacent ones of the fourth portions, and
   each of the fifth portions is bent from each of the fourth portions.
Clause 10. The display panel of clause 9, wherein
   the second isolation portion further includes sixth portions,
   each of the sixth portions is disposed between adjacent ones of the fourth portions,
   each of the sixth portions is bent from each of the fourth portions, and
   each of the sixth portions is spaced apart from each of the fifth portions.
Clause 11. The display panel of any preceding clause, wherein each of the first light-emitting unit and the second light-emitting unit includes first emitting parts, second emitting parts and third emitting parts emitting light of different colors.
Clause 12. The display panel of clause 11, further comprising:
   first light emitting devices, second light emitting devices and third light emitting devices, wherein each of the first light emitting devices, the second light emitting devices and the third light emitting devices include a first electrode, a second electrode facing the first electrode, and a light-emitting layer disposed between the first electrode and the second electrode, wherein the first light emitting devices, the second light emitting devices and the third light emitting devices respectively correspond to the first emitting parts, the second emitting parts and the third emitting parts ; and
   a first transistor, a second transistor, and a third transistor respectively connected to the first light emitting devices, the second light emitting devices and the third light emitting devices,
   wherein the separator isolates the second electrodes of the first light emitting devices, the second light emitting devices and the third light emitting devices from each other.
Clause 13. The display panel of clause 12, further comprising:
   first connection wirings, second connection wirings and third connection wirings respectively connecting the first light emitting devices, the second light emitting devices and the third light emitting devices to the first transistor, the second transistor, and the third transistor to each other, wherein
   each of the first connection wirings, the second connection wirings and the third connection wirings include:
      each of first emission connection parts, second emission connection parts and third emission connection parts connected to each corresponding one of the first light emitting devices, the second light emitting devices and the third light emitting devices; and
      each of first driver connection parts, second driver connection parts and third driver connection parts connected to each corresponding one of the first transistor, the second transistor, and the third transistor, and
   each of the first emission connection parts, the second emission connection parts and the third emission connection parts is connected to each of the second electrodes of the first light emitting devices, the second light emitting devices and the third light emitting devices.
Clause 14. The display panel of any preceding clause, wherein
   the separator includes one face, another face facing the one face, and a side face disposed between the one face and the another face, in a cross-sectional view, and
   the side face is inclined with respect to the one face.
Clause 15. The display panel of clause 14, wherein
   the side face includes a first side face and a second side face spaced apart from the first side face in a direction perpendicular to a thickness direction, and
   a first angle at which the first side face is inclined with respect to the one face and a second angle at which the second side face is inclined with respect to the one face are different from each other.
Clause 16. The display panel of clause 14 or clause 15, wherein
   the another face includes a groove,
   the groove is defined by a first inner side face, a second inner side face spaced apart from the first inner side face, and an inner bottom face disposed between the first inner side face and the second inner side face, and
   each of the first inner side face and the second inner side face is inclined with respect to the inner bottom face.
Clause 17. A display panel comprising:
   a first light-emitting unit and a second light-emitting unit spaced apart from each other, wherein
   each of the first light-emitting unit and the second light-emitting unit includes an separator, at least one light emitting device, and at least one transistor,
   the separator includes:
      at least two first isolation portions extending in a first direction and spaced apart from each other; and
      an intersection disposed between the at least two first isolation portions,
   a first width in a second direction of the intersection is greater than a width in the second direction of one of the at least two first isolation portions, and
   the second direction intersects the first direction.
Clause 18. The display panel of clause 17, wherein
   each of the first light-emitting unit and the second light-emitting unit includes a emitting part corresponding to the at least one light emitting device and emitting light, and
   an edge of the emitting part and an edge of the intersection have a same curvature in a plan view.
Clause 19. The display panel of clause 17 or clause 18, wherein
   the separator further includes a second isolation portion extending from the intersection in a direction intersecting a direction in which the at least two first isolation portions extend, and
   a second width in the first direction of the intersection is greater than a width in the first direction of the second isolation portion.
Clause 20. The display panel of clause 19, wherein the intersection has a substantially rectangular shape in which a second opening is defined in a plan view.
Clause 21. The display panel of clause 20, wherein
   the intersection includes:
      four outer edges defining the substantially rectangular shape; and
      inner edges respectively spaced apart from the outer edges and defining the second opening, and
   each of the first width and the second width is defined as a straight line distance between two outer edges spaced apart from each other among the four outer edges.
Clause 22. The display panel of any one of clauses 17 to 21, wherein
   each of the at least two first isolation portions includes:
      first portions spaced apart from each other; and
      second portions,
   each of the second portions is disposed between adjacent ones of the first portions, and
   each of the second portions is bent from each of the first portions.
Clause 23. The display panel of any one of clauses 17 to 22, wherein each of the first light-emitting unit and the second light-emitting unit includes first emitting parts, second emitting parts and third emitting parts emitting light of different colors.
Clause 24. The display panel of any one of clauses 17 to 23, wherein
   the first light-emitting unit includes a first light emitting device and a first transistor electrically connected to the first light emitting device,
   the second light-emitting unit includes a second light emitting device and a second transistor electrically connected to the second light emitting device,
   each of the first light emitting device and the second light emitting device includes a first electrode, a second electrode facing the first electrode, and a light-emitting layer disposed between the first electrode and the second electrode, and
   the separator isolates the second electrode of the first light emitting device and the second electrode of the second light emitting device from each other while the separator is disposed between the second electrode of the first light emitting device and the second electrode of the second light emitting device.
Clause 25. The display panel of clause 24, further comprising:
   a first connection wiring electrically connecting the first light emitting device to the first transistor; and
   a second connection wiring electrically connecting the second light emitting device to the second transistor, wherein
   each of the first connection wiring and the second connection wiring includes:
      an emission connection part electrically connected to a corresponding one of the at least one light emitting device; and
      a driver connection part electrically connected to a corresponding one of the at least one transistor,
   the emission connection part of the first connection wiring is electrically connected to the second electrode of the first light emitting device, and
   the emission connection part of the second connection wiring is electrically connected to the second electrode of the second light emitting device.

## Claims

1. A display panel comprising:
a first light-emitting unit and a second light-emitting unit spaced apart from each other, wherein
each of the first light-emitting unit and the second light-emitting unit includes a separator and at least one emitting part,
the separator includes a first isolation portion,
the first isolation portion includes:
first portions spaced apart from each other; and
second portions,
each of the second portions is disposed between corresponding two adjacent ones of the first portions, and
each of the second portions is bent from a corresponding one of the first portions.

2. The display panel of claim 1, wherein
each of the second portions extend in a first direction, and
each of the first portions extend in a second direction intersecting the first direction.

3. The display panel of claim 1 or 2, wherein
the first isolation portion further includes third portions,
each of the third portions is disposed between corresponding two adjacent ones of the first portions,
each of the third portions is bent from a corresponding one of the first portions, and
each of the third portions is spaced apart from a corresponding one of the second portions.

4. The display panel of claim 3, wherein two first portions adjacent to each other among the first portions, a second portion disposed between the two adjacent first portions among the second portions, and a third portion disposed between the two adjacent first portions among the third portions define a first opening.

5. The display panel of claim 3 or 4, wherein each of the third portions extends in parallel to a direction in which each of the second portions extends.

6. The display panel of any preceding claim, wherein
the first isolation portion includes at least two first isolation portions,
the separator further includes an intersection disposed between the two first isolation portions, and
a first width in a first direction of the intersection is greater than a width in the first direction of each of the two first isolation portions.

7. The display panel of claim 6, wherein an edge of one or more of the at least one emitting part and an edge of the intersection have a same curvature in a plan view.

8. The display panel of claim 6 or 7, wherein
the separator further includes a second isolation portion extending from the intersection in a direction intersecting a direction in which the first isolation portion extends,
a second width in a second direction of the intersection is greater than a width in the second direction of the second isolation portion, and the first direction intersects the second direction.

9. The display panel of claim 8, wherein
the second isolation portion includes:
fourth portions spaced apart from each other; and
fifth portions,
each of the fifth portions is disposed between corresponding two adjacent ones of the fourth portions, and
each of the fifth portions is bent from a corresponding one of the fourth portions.

10. The display panel of claim 9, wherein
the second isolation portion further includes sixth portions,
each of the sixth portions is disposed between corresponding two adjacent ones of the fourth portions,
each of the sixth portions is bent from a corresponding one of the fourth portions, and
each of the sixth portions is spaced apart from a corresponding one of the fifth portions.

11. The display panel of any preceding claim, wherein each of the first light-emitting unit and the second light-emitting unit includes a first emitting part, a second emitting part and a third emitting part, each configured to emit light of a different color.

12. The display panel of claim 11, further comprising:
a first light emitting device, a second light emitting device and a third light emitting device, wherein each of the first light emitting device, the second light emitting device and the third light emitting device include a first electrode, a second electrode facing the first electrode, and a light-emitting layer disposed between the first electrode and the second electrode, wherein the first light emitting device, the second light emitting device and the third light emitting device respectively correspond to the first emitting part, the second emitting part and the third emitting part; and
a first transistor, a second transistor, and a third transistor respectively connected to the first light emitting device, the second light emitting device and the third light emitting device,
wherein the separator isolates the second electrodes of the first light emitting device, the second light emitting device and the third light emitting device from each other.

13. The display panel of claim 12, further comprising:
a first connection wiring, a second connection wiring and a third connection wiring respectively connecting the first light emitting device, the second light emitting device and the third light emitting device to the first transistor, the second transistor, and the third transistor, wherein
each of the first connection wiring, the second connection wiring and the third connection wiring include:
each of a first emission connection part, a second emission connection part and a third emission connection part connected to each corresponding one of the first light emitting device, the second light emitting device and the third light emitting device; and
each of a first driver connection part, a second driver connection part and a third driver connection part connected to each corresponding one of the first transistor, the second transistor, and the third transistor, and
each of the first emission connection part, the second emission connection part and the third emission connection part is connected to each of the second electrodes of the first light emitting device, the second light emitting device and the third light emitting device.

14. The display panel of any preceding claim, wherein
the separator includes one face, another face facing the one face, and a side face disposed between the one face and the another face, in a cross-sectional view, and
the side face is inclined with respect to the one face.

15. The display panel of claim 14, wherein
the side face includes a first side face and a second side face spaced apart from the first side face in a direction perpendicular to a thickness direction, and
a first angle at which the first side face is inclined with respect to the one face and a second angle at which the second side face is inclined with respect to the one face are different from each other; and/or
wherein the another face includes a groove,
the groove is defined by a first inner side face, a second inner side face spaced apart from the first inner side face, and an inner bottom face disposed between the first inner side face and the second inner side face, and
each of the first inner side face and the second inner side face is inclined with respect to the inner bottom face.
